(19) Europäisches Patentamt
European Patent Office
Office européen des brevets

(11) EP 3 120 396 B1

(12) **EUROPÄISCHE PATENTSCHRIFT**

(45) Veröffentlichungstag und Bekanntmachung des Hinweises auf die Patenterteilung:
**02.06.2021 Patentblatt 2021/22**

(21) Anmeldenummer: **15705208.5**

(22) Anmeldetag: **19.02.2015**

(51) Int Cl.:
***H01L 51/54*** *(2006.01)* ***C09K 11/02*** *(2006.01)*
***C09K 11/06*** *(2006.01)* *H01L 51/50* *(2006.01)*

(86) Internationale Anmeldenummer:
**PCT/EP2015/000379**

(87) Internationale Veröffentlichungsnummer:
**WO 2015/139808 (24.09.2015 Gazette 2015/38)**

# (54) ORGANISCHE ELEKTROLUMINESZENZVORRICHTUNG

ORGANIC ELECTROLUMINESCENT DEVICE

DISPOSITIF ORGANIQUE ÉLECTROLUMINESCENT

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **18.03.2014 EP 14001002**

(43) Veröffentlichungstag der Anmeldung:
**25.01.2017 Patentblatt 2017/04**

(73) Patentinhaber: **Merck Patent GmbH**
**64293 Darmstadt (DE)**

(72) Erfinder:
- **PARHAM, Amir Hossain**
  **60486 Frankfurt am Main (DE)**
- **STOESSEL, Philipp**
  **60389 Frankfurt am Main (DE)**
- **PFLUMM, Christof**
  **64291 Darmstadt (DE)**
- **JATSCH, Anja**
  **60489 Frankfurt am Main (DE)**
- **KAISER, Joachim**
  **64289 Darmstadt (DE)**

(56) Entgegenhaltungen:
**EP-A1- 2 213 641** **US-A1- 2011 266 526**
**US-A1- 2013 306 945**

- **HIROKI UOYAMA ET AL: "Highly efficient organic light-emitting diodes from delayed fluorescence", NATURE, vol. 492, no. 7428, 12 December 2012 (2012-12-12), pages 234-238, XP055048388, London ISSN: 0028-0836, DOI: 10.1038/nature11687**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 3 120 396 B1

**Beschreibung**

Die vorliegende Erfindung betrifft organische Elektrolumineszenzvorrichtungen, welche Mischungen aus einem lumineszenten Material mit einem geringen Singulett-Triplett-Abstand und Matrixmaterialien mit mindestens einer Triphenylengruppe und/oder Azatriphenylengruppe, die bis zu sechs Aza-Stickstoffatome aufweist (TP-Verbindung), enthalten.

Der Aufbau organischer Elektrolumineszenzvorrichtungen (OLEDs), in denen organische Halbleiter als funktionelle Materialien eingesetzt werden, ist beispielsweise in US 4539507, US 5151629, EP 0676461 und WO 98/27136 beschrieben. Als emittierende Materialien werden hierbei insbesondere auch metallorganische Iridium- und Platinkomplexe eingesetzt, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich.

Trotz der guten Ergebnisse, die mit metallorganischen Iridium- und Platinkomplexen erzielt werden, weisen diese jedoch auch eine Reihe von Nachteilen auf: So handelt es sich bei Iridium und Platin um seltene und teure Metalle. Es wäre daher zur Ressourcenschonung wünschenswert, die Verwendung dieser seltenen Metalle vermeiden zu können. Weiterhin weisen derartige Metallkomplexe teilweise eine geringere thermische Stabilität auf als rein organische Verbindungen, so dass auch aus diesem Grund die Verwendung rein organischer Verbindungen vorteilhaft wäre, sofern diese zu vergleichbar guten Effizienzen führen. Weiterhin sind blau, insbesondere tiefblau phosphoreszierende Iridium- bzw. Platinemitter mit hoher Effizienz und Lebensdauer derzeit technisch nur schwierig zu verwirklichen, so dass es auch hier Verbesserungsbedarf gibt. Weiterhin gibt es insbesondere bei der Lebensdauer phosphoreszierender OLEDs, welche Ir- oder Pt-Emitter enthalten, Verbesserungsbedarf, wenn die OLED bei höherer Temperatur betrieben wird, wie dies für einige Anwendungen erforderlich ist.

Eine alternative Entwicklung ist die Verwendung von Emittern, die thermisch aktivierte verzögerte Fluoreszenz (thermally activated delayed fluorescence, TADF) zeigen (z. B. H. Uoyama et al., Nature 2012, Vol. 492, 234). Hier handelt es sich um organische Materialien, bei denen der energetische Abstand zwischen dem niedrigsten Triplettzustand $T_1$ und dem ersten angeregten Singulettzustand $S_1$ so klein ist, dass dieser Energieabstand kleiner oder im Bereich der thermischen Energie liegt. Aus quantenstatistischen Gründen entstehen bei elektronischer Anregung in der OLED die angeregten Zustände zu 75 % im Triplettzustand und zu 25 % im Singulettzustand. Da rein organische Moleküle üblicherweise nicht aus dem Triplettzustand emittieren können, können 75 % der angeregten Zustände nicht für die Emission genutzt werden, wodurch prinzipiell nur 25 % der Anregungsenergie in Licht umgewandelt werden können. Ist nun jedoch der energetische Abstand zwischen dem niedrigsten Triplettzustand und dem niedrigsten angeregten Singulettzustand nicht oder nicht wesentlich größer als die thermische Energie, die durch kT beschrieben wird, so ist aus dem Triplettzustand durch thermische Anregung der erste angeregte Singulettzustand des Moleküls zugänglich und kann thermisch besetzt werden. Da dieser Singulettzustand ein emissiver Zustand ist, aus dem Fluoreszenz möglich ist, kann dieser Zustand zur Erzeugung von Licht verwendet werden. Somit ist prinzipiell die Umwandlung von bis zu 100 % der elektrischen Energie in Licht möglich bei der Verwendung rein organischer Materialien als Emitter. So wird im Stand der Technik eine externe Quanteneffizienz von mehr als 19 % beschrieben, was in derselben Größenordnung wie für phosphoreszierende OLEDs liegt. Somit ist es mit derartigen rein organischen Materialien möglich, sehr gute Effizienzen zu erreichen und gleichzeitig die Verwendung seltener Metalle wie Iridium oder Platin zu vermeiden. Weiterhin ist es mit solchen Materialien auch möglich, hocheffiziente blau emittierende OLEDs zu erzielen.

Im Stand der Technik werden Emitter, die thermisch aktivierte verzögerte Fluoreszenz zeigen (im Folgenden TADF-Verbindung genannt), in Kombination mit verschiedenen Matrixmaterialien eingesetzt, beispielsweise mit Carbazolderivaten (H. Uoyama et al., Nature 2012, 492, 234; Endo et al., Appl. Phys. Lett. 2011, 98, 083302; Nakagawa et al., Chem. Commun. 2012, 48, 9580; Lee et al., Appl. Phys. Lett. 2012, 101, 093306/1), Phosphinoxid-Dibenzothiophenderivaten (H. Uoyama et al., Nature 2012, 492, 234) oder Silanderivaten (Mehes et al., Angew. Chem. Int. Ed. 2012, 51, 11311; Lee et al., Appl. Phys. Lett. 2012, 101, 093306/1). Matrixmaterialien mit Triphenylengruppen für organische fluoreszierende Verbindungen sind bereits aus der EP2213641 A1 bekannt.

Generell gibt es bei organischen Elektrolumineszenzvorrichtungen, die Emission nach dem TADF-Mechanismus zeigen, noch weiteren Verbesserungsbedarf, insbesondere im Hinblick auf Effizienz, Spannung und Lebensdauer.

Die der vorliegenden Erfindung zugrunde liegende technische Aufgabe ist somit die Bereitstellung von OLEDs, deren Emission auf TADF basiert und die verbesserte Eigenschaften aufweisen, insbesondere in Bezug auf eine oder mehrere der genannten Eigenschaften.

Überraschenderweise wird die Aufgabe gelöst durch organische Elektrolumineszenzvorrichtungen und Verfahren gemäß den Patentansprüchen. Gegenstand der Erfindung ist eine organische Elektrolumineszenzvorrichtung, enthaltend Kathode, Anode und emittierende Schicht, die die folgenden Verbindungen enthält:

(A) mindestens eine lumineszente organische Verbindung, die einen Abstand zwischen dem niedrigsten Triplettzustand $T_1$ und dem ersten angeregten Singulettzustand $S_1$ von $\leq$ 0.15 eV aufweist (TADF-Verbindung); und

(B) mindestens eine organische Verbindung mit mindestens einer Triphenylengruppe und/oder Azatriphenylengruppe, die bis zu sechs Aza-Stickstoffatome aufweist (TP-Verbindungen), wobei die TP-Verbindung die Formel (1) oder (2), gemäß Anspruch 1, aufweist.

Im Folgenden wird die lumineszente organische Verbindung, die einen Abstand zwischen dem niedrigsten Triplettzustand $T_1$ und dem ersten angeregten Singulettzustand $S_1$ von $\leq 0.15$ eV aufweist, näher beschrieben. Hierbei handelt es sich um eine Verbindung, die TADF (thermally activated delayed fluorescence) zeigt. Diese Verbindung wird in der folgenden Beschreibung als "TADF-Verbindung" bezeichnet.

Eine organische Verbindung im Sinne der vorliegenden Erfindung ist eine kohlenstoffhaltige Verbindung, die keine Metalle enthält. Insbesondere ist die organische Verbindung aus den Elementen C, H, D, B, Si, N, P, O, S, F, Cl, Br und I aufgebaut.

Eine lumineszente Verbindung im Sinne der vorliegenden Erfindung ist eine Verbindung, die in der Lage ist, unter optischer Anregung in einer Umgebung, wie sie in der organischen Elektrolumineszenzvorrichtung vorliegt, bei Raumtemperatur Licht zu emittieren. Dabei weist die Verbindung bevorzugt eine Lumineszenzquanteneffizienz (Photolumineszenzquanteneffizienz; PLQE) von mindestens 40 % auf, besonders bevorzugt von mindestens 50 %, ganz besonders bevorzugt von mindestens 60 % und insbesondere bevorzugt von mindestens 70 %. Dabei wird die Lumineszenzquanteneffizienz bestimmt in einer Schicht in Mischung mit dem Matrixmaterial, wie sie in der organischen Elektrolumineszenzvorrichtung verwendet werden soll. Wie die Bestimmung der Lumineszenzquanteneffizienz im Sinne der vorliegenden Erfindung durchgeführt wird, ist im Beispielteil ausführlich allgemein beschrieben.

Weiterhin ist es bevorzugt, wenn die TADF-Verbindung eine kurze Abklingzeit aufweist. Dabei ist die Abklingzeit bevorzugt $\leq 50$ µs, mehr bevorzugt < 20 µs , noch mehr bevorzugt < 10 µs. Wie die Bestimmung der Abklingzeit im Sinne der vorliegenden Erfindung durchgeführt wird, ist im Beispielteil ausführlich allgemein beschrieben.

Die Energie des niedrigsten angeregten Singulettzustands ($S_1$) und des niedrigsten Triplettzustands ($T_1$) werden durch quantenchemische Rechnung bestimmt. Wie diese Bestimmung im Sinne der vorliegenden Erfindung durchgeführt wird, ist im Beispielteil ausführlich allgemein beschrieben.

Wie oben beschrieben, darf der Abstand zwischen $S_1$ und $T_1$ maximal 0.15 eV betragen, damit es sich bei der Verbindung um eine TADF-Verbindung im Sinne der vorliegenden Erfindung handelt. Bevorzugt ist der Abstand zwischen $S_1$ und $T_1 \leq 0.10$ eV, besonders bevorzugt $\leq 0.08$ eV, ganz besonders bevorzugt $\leq 0.05$ eV.

Bei der TADF-Verbindung handelt es sich bevorzugt um eine aromatische Verbindung, die sowohl Donor- wie auch Akzeptorsubstituenten aufweist, wobei das LUMO und das HOMO der Verbindung räumlich nur schwach überlappen. Was unter Donor- bzw. Akzeptorsubstituenten verstanden wird, ist dem Fachmann prinzipiell bekannt. Der Donorsubstituent ist in einer bevorzugten Ausführungsform elektronenschiebend und übt dabei einen +M -Effekt (positiven mesomeren Effekt) aus.

Geeignete Donorsubstituenten weisen insbesondere ein Atom mit einem freien Elektronenpaar auf, wie ein N-, S- oder O-Atom. Bevorzugt sind dabei 5-Ring-Heteroarylgruppen mit genau einem Heteroringatom, an die auch weitere Arylgruppen ankondensiert sein können. Bevorzugt sind insbesondere Carbazolgruppen bzw. Carbazolderivate, die jeweils bevorzugt über N an die aromatische Verbindung gebunden sind. Dabei können diese Gruppen auch weiter substituiert sein. Geeignete Donorsubstituenten sind weiterhin auch Diaryl- bzw. Heteroarylaminogruppen.

Geeignete Akzeptorsubstituenten sind insbesondere Cyanogruppen, aber auch beispielsweise elektronenarme Heteroarylgruppen, beispielsweise Triazin, die auch weiter substituiert sein können. Der Akzeptorsubstituent ist in einer bevorzugten Ausführungsform elektronenziehend und übt dabei einen -M -Effekt (negativen mesomeren Effekt) aus.

In einer bevorzugten Ausführungsform weist die TADF-Verbindung eine aromatische Ringstruktur auf, die mindestens eine Heteroarylgruppe mit mindestens einem N als Heteroatom aufweist, bevorzugt ausgewählt aus Carbazol, Azaanthracen und Triazin; und/oder die TADF-Verbindung weist mindestens eine Arylgruppe, insbesondere eine Benzolgruppe, auf, die mit mindestens einer Cyanogruppe substituiert ist, insbesondere mit einer, zwei oder drei Cyanogruppen.

In der Mischung aus TADF-Verbindung und TP-Verbindung wird die TP-Verbindung als die Matrix angesehen. Um Exziplexbildung in der emittierenden Schicht zu vermeiden, ist es bevorzugt, wenn für

LUMO(TADF), also das LUMO der TADF-Verbindung, und das
HOMO(Matrix), also das HOMO der TP-Verbindung, gilt:
LUMO(TADF) - HOMO(Matrix) > $S_1$(TADF) - 0.4 eV;

besonders bevorzugt:
LUMO(TADF) - HOMO(Matrix) > $S_1$(TADF) - 0.3 eV;
und ganz besonders bevorzugt:
LUMO(TADF) - HOMO(Matrix) > $S_1$(TADF) - 0.2 eV.

Dabei ist $S_1$(TADF) der erste angeregte Singulettzustand $S_1$ der TADF-Verbindung.

Es gehört zum allgemeinen Fachwissen des Fachmanns, welche Materialien sich generell als TADF-Verbindungen eignen. Folgende Referenzen offenbaren beispielsweise Materialien, die potentiell als TADF-Verbindungen geeignet sind:

- Tanaka et al., Chemistry of Materials 25(18), 3766 (2013)
- Lee et al., Journal of Materials Chemistry C 1(30), 4599 (2013)
- Zhang et al., Nature Photonics advance online publication, 1 (2014), doi: 10.1038/nphoton.2014.12
- Serevicius et al., Physical Chemistry Chemical Physics 15(38), 15850 (2013)
- Li et al., Advanced Materials 25(24), 3319 (2013)
- Youn Lee et al., Applied Physics Letters 101(9), 093306 (2012)
- Nishimoto et al., Materials Horizons 1, 264 (2014), doi: 10.1039/C3MH00079F
- Valchanov et al., Organic Electronics, 14(11), 2727 (2013)
- Nasu et al., ChemComm, 49, 10385 (2013)

Weiterhin enthalten die folgenden Patentanmeldungen potentielle TADF Verbindungen: WO 2013/154064, WO 2013/133359, WO 2013/161437, WO 2013/081088, WO 2013/081088, WO 2013/011954, JP 2013/116975 und US 2012/0241732.

Weiterhin kann der Fachmann diesen Veröffentlichungen Designprinzipien für TADF-Verbindungen entnehmen. Z.B. zeigen Valchanov et al., wie sich die Farbe von TADF-Verbindungen anpassen lässt.

Beispiele für geeignete TADF-Verbindungen sind die in der folgenden Tabelle aufgeführten Strukturen:

| | | |
|---|---|---|
| 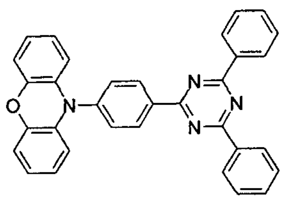 | 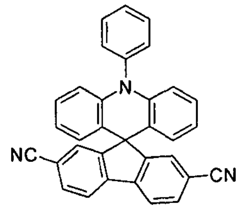 | 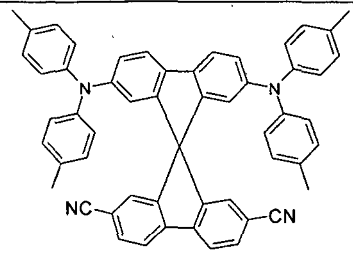 |
| 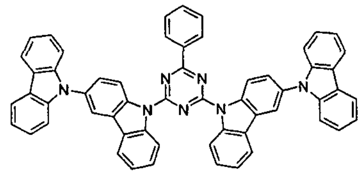 | 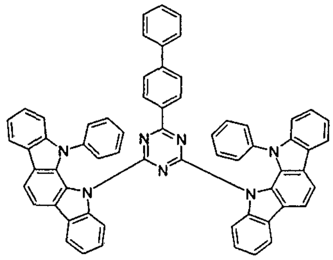 | 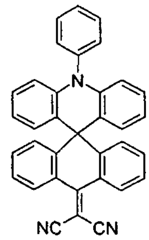 |
| 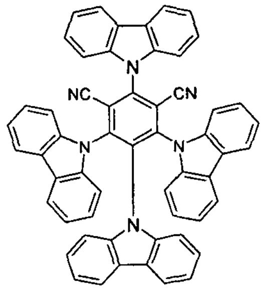 | 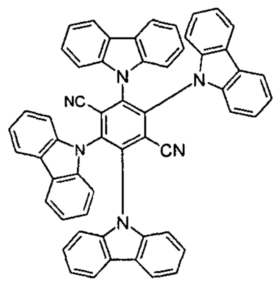 | 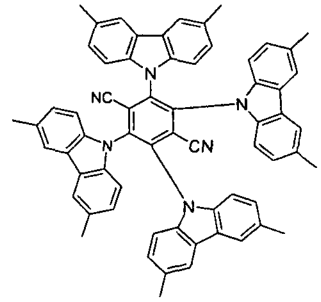 |
| 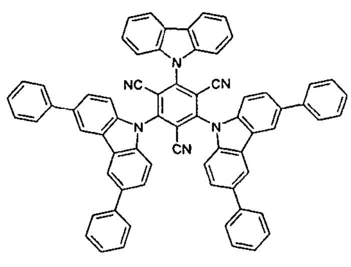 | 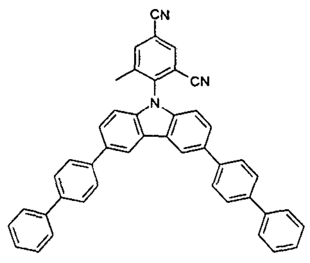 | 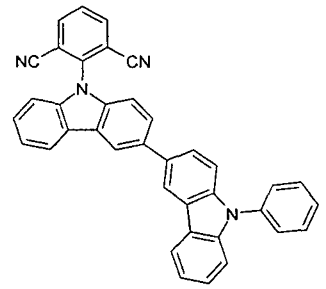 |
| 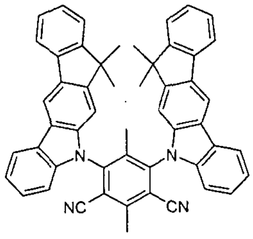 | 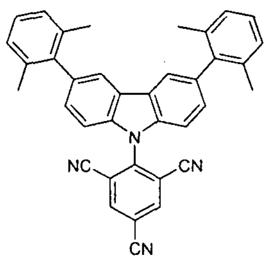 | 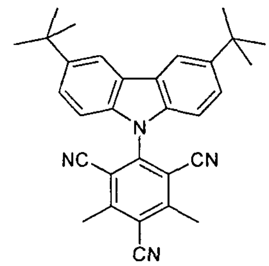 |

| | | |
|---|---|---|
| 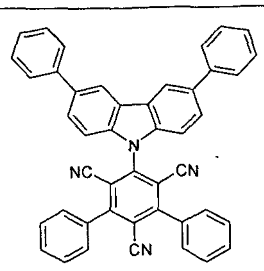 | 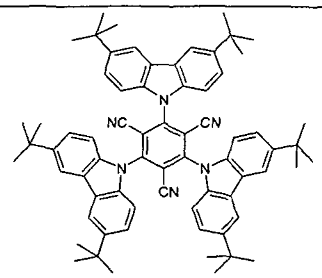 | 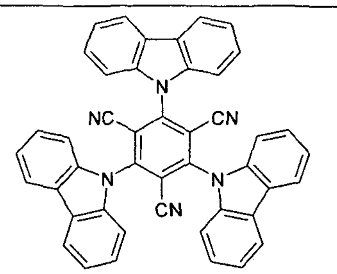 |

In einer bevorzugten Ausführungsform der Erfindung ist die TP-Verbindung das Matrixmaterial für die TADF-Verbindung. Dabei ist die TADF-Verbindung in der Mischung die emittierende Verbindung, d. h. die Verbindung, deren Emission aus der emittierenden Schicht beobachtet wird, während die TP-Verbindung, die als Matrixmaterial dient, nicht oder nicht wesentlich zur Emission der Mischung beiträgt.

In einer bevorzugten Ausführungsform der Erfindung besteht die emittierende Schicht nur aus der TP-Verbindung und der TADF-Verbindung. In einer weiteren Ausführungsform der Erfindung enthält die emittierende Schicht außer der TP-Verbindung und der TADF-Verbindung noch ein oder mehrere weitere Verbindungen.

Damit die TADF-Verbindung die emittierende Verbindung in der Mischung der emittierenden Schicht ist, ist es bevorzugt, dass die niedrigste Triplettenergie der TP-Verbindung maximal 0.1 eV niedriger ist als die niedrigste Triplettenergie der TADF-Verbindung. Insbesondere bevorzugt ist $T_1$ (Matrix) $\geq T_1$(TADF). Besonders bevorzugt gilt: $T_1$ (Matrix) - $T_1$(TADF) $\geq$ 0.1 eV, ganz besonders bevorzugt $T_1$(Matrix) - $T_1$(TADF) $\geq$ 0.2 eV. Dabei steht $T_1$(Matrix) für die niedrigste Triplettenergie der TP-Verbindung und $T_1$(TADF) für die niedrigste Triplettenergie der TADF-Verbindung. Dabei wird die niedrigste Triplettenergie der Matrix durch quantenchemische Rechnung bestimmt, wie hinten im Beispielteil allgemein beschrieben.

Die erfindungsgemäße organische Elektrolumineszenzvorrichtung enthält mindestens eine organische Verbindung mit mindestens einer Triphenylengruppe und/oder Azatriphenylengruppe, die bis zu sechs Aza-Atome aufweist, wobei die Verbindung der Formel (1) oder (2) gemäß Anspruch 1 entspricht.

Diese Verbindungen werden im Rahmen dieser Anmeldung als "TP-Verbindungen" bezeichnet.

Triphenylen (CAS 217-59-4; Benzo[*l*]phenanthren; $C_{18}H_{12}$) ist ein polycyclischer aromatischer Kohlenwasserstoff aus vier Benzolringen. Monoazatriphenylen ist eine entsprechende heterocyclische aromatische Verbindung, bei der eine der C-H Gruppen der Triphenylengruppe durch ein Stickstoffatom ersetzt ist ($C_{17}H_{11}N$). Erfindungsgemäß können die Azatriphenylene bis zu sechs Aza-Atome in der zentralen Triphenylengruppe aufweisen. Azatriphenylene mit zwei oder mehr Aza-Atomen in der Triphenylengruppe können als Polyazatriphenylene bezeichnet werden. Die Azatriphenylengruppe ist besonders bevorzugt eine Monoazatriphenylengruppe oder eine Diazatriphenylengruppe. Sie kann auch eine Triaza-, Tetraaza-, Pentaaza- oder Hexaazatriphenylengruppe sein.

Bei der erfindungsgemäßen TP-Verbindung ist die Triphenylengruppe oder die Azatriphenylengruppe substituiert. Dabei können auch weitere aromatische Ringe, insbesondere Benzolringe, als Substituenten vorhanden sein, die mit der Triphenylengruppe und/oder Azatriphenylengruppe anelliert sind. Die organische Verbindung kann daher eine Triphenylengruppe aufweisen, die Bestandteil einer polyzyklischen aromatischen Struktur mit mehr als vier Ringen ist. So kann die TP-Verbindung beispielsweise einen oder mehrere an die zentrale Triphenylengruppe und/oder Azatriphenylengruppe anellierte Benzolringe aufweisen. Dabei sind aromatische Ringe so anelliert, dass sie mit der Triphenylengruppe und/oder Azatriphenylengruppe zwei gemeinsame C-Atome, also eine gemeinsame Kante, aufweisen. In der chemischen Nomenklatur werden solche Ringsysteme, die eine Triphenylengruppe und weitere anellierte Benzolringe oder andere aromatische Gruppen aufweisen, zum Teil nach einer höherwertigen Grundstruktur benannt, wie Chrysen, Pyren, Tetraphenylen oder Trinaphthylen. Solche Verbindungen sind TP-Verbindungen im Sinne der Erfindung, wenn sie gleichzeitig eine Triphenylengruppe (Triphenylenstruktureinheit) aufweisen. Dies gilt analog für erfindungsgemäße TP-Verbindungen mit Azatriphenylengruppe.

Gemäß der Erfindung weist die TP-Verbindung die Formel (1) oder (2) auf:

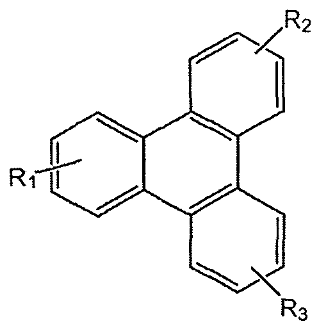

(1)

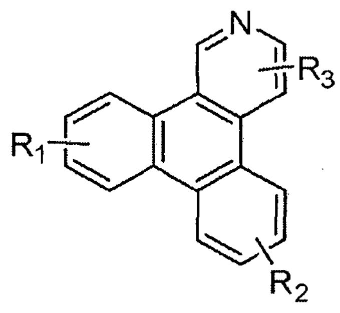

(2)

oder wobei die TP-Verbindung der Formel (2) entspricht und bis zu fünf weitere Aza-Stickstoffatome aufweist, die C-H Gruppen der in Formel (2) gezeigten Monoazatriphenylengruppe ersetzen, wobe
i die Reste $R_1$, $R_2$ und $R_3$ unabhängig voneinander ausgewählt sind,
wobei jeweils keiner, einer oder mehrere Reste $R_1$, $R_2$ oder $R_3$ vorhanden sein können, wobei mehrere Reste von $R_1$, von $R_2$ oder von $R_3$ jeweils unabhängig voneinander ausgewählt werden,

wobei die Reste $R_1$, $R_2$ oder $R_3$ ausgewählt sind aus

(i) einer aromatischen Gruppe, die mit der Triphenylengruppe oder Azatriphenylengruppe ein konjugiertes System bildet, wobei die aromatische Gruppe 5 bis 80 aromatische Ringatome aufweist, die mit einem oder mehreren Resten $R_4$ substituiert sein können, wobei $R_4$ unabhängig voneinander ausgewählt ist aus H, D, F, Cl, F, Br, unverzweigtem Alkyl mit 1 bis 20 C-Atomen, oder verzweigtem oder cyclischem Alkyl mit 3 bis 20 C-Atomen, wobei zwei oder mehr Reste $R_4$ miteinander verknüpft sein können und einen Ring bilden können, und

(ii) einem Alkylrest $R_5$, ausgewählt aus unverzweigtem Alkyl- mit 1 bis 20 C-Atomen, verzweigtem oder cyclischem Alkyl- mit 3 bis 20 C-Atomen, wobei zwei Reste $R_5$ miteinander verknüpft sein können und einen Ring bilden können,

mit der Maßgabe, dass mindestens ein Rest $R_1$, $R_2$ oder $R_3$ vorhanden ist, der eine aromatische Gruppe (i) ist.

Jede Verbindung der Formeln (1) oder (2) weist mindestens vier aromatische Ringe auf, die Bestandteil der Triphenylen- bzw. Azatriphenylen-Grundstruktur (Gruppe) sind. Die Grundstruktur weist jeweils vier anellierte Ringe auf, wobei drei äußere Ringe und ein innerer Ring unterschieden werden können. Die vier Ringe bilden ein aromatisches System. Die Reste $R_1$, $R_2$ und $R_3$ sind Substituenten der äußeren Ringen. Die Reste $R_1$, $R_2$ und $R_3$ werden unabhängig voneinander ausgewählt. Jeder äußere Ring kann keinen, einen oder mehrere Reste als Substituenten aufweisen. Dabei kann ein äußerer Ring zwei, drei oder vier Substituenten aufweisen, die zueinander identisch oder voneinander verschieden sein können. Erfindungsgemäß weist ein äußerer Ring meistens keinen oder nur einen einzigen Rest $R_1$, $R_2$ oder $R_3$ auf.

Die Verbindung kann der Formel (2) entsprechen und zusätzlich bis zu fünf weitere Aza-Stickstoffatome aufweisen, die C-H Gruppen der in Formel (2) gezeigten Monoazatriphenylengruppe ersetzen, also insgesamt bis zu sechs Aza-Stickstoffatome aufweisen. Solche Verbindungen mit zwei oder mehr Aza-Stickstoffatomen weisen eine Polyazatriphenylengruppe auf. Dabei ist nicht ausgeschlossen, dass die Reste $R_1$, $R_2$ und $R_3$ weitere Aza-Stickstoffatome aufweisen. Es ist erfindungsgemäß bevorzugt, dass die Verbindung der Formel (2) eine Monoazatriphenylengruppe aufweist.

Mindestens ein Rest $R_1$, $R_2$ und $R_3$ weist eine aromatische Gruppe auf. Dabei kann der Rest $R_1$, $R_2$ oder $R_3$ aus der aromatischen Gruppe bestehen, oder der Rest $R_1$, $R_2$ oder $R_3$ kann zusätzlich mindestens eine weitere, nicht aromatische, Gruppe aufweisen. Die aromatische Gruppe bildet mit der Triphenylengruppe oder Azatriphenylengruppe ein übergeordnetes, konjugiertes System, das ein konjugiertes aromatisches System ist. Bevorzugt weisen alle Reste $R_1$, $R_2$ und $R_3$ , soweit vorhanden, solche aromatischen Gruppen auf.

In einer bevorzugten Ausführungsform der Erfindung ist eine aromatische Gruppe $R_1$, $R_2$ oder $R_3$ über eine konjugierte C-C Einfachbindung mit der Triphenylengruppe oder Azatriphenylengruppe verbunden. Aromatische Ringe oder Ringsysteme, die über C-C-Einfachbindungen miteinander verbunden sind, werden im Allgemeinen als übergeordnete aromatische Ringsysteme angesehen. Die einfachste Verbindung dieser Art ist Biphenyl, bei der zwei Benzolringe über eine C-C-Einfachbindung miteinander verbunden sind, so dass beide Ringe ein konjugiertes aromatisches Ringsystem bilden.

In einer weiteren bevorzugten Ausführungsform der Erfindung ist $R_1$, $R_2$ und/oder $R_3$ eine mit der Triphenylengruppe und/oder Azatriphenylengruppe anellierte (kondensierte) aromatische Gruppe oder weist eine solche Gruppe auf. Anellierte aromatische Gruppen sind über mindestens zwei Ringglieder miteinander verbunden. Bevorzugt ist die anellierte aromatische Gruppe ein Benzolring. Bevorzugt weist die organische Verbindung insgesamt eine oder mehrere, beispielsweise zwei, drei, vier, fünf oder sechs weitere Benzolringe auf, die mit der Triphenylengruppe und/oder Azatriphenylengruppe zu einer polycyclischen aromatischen Verbindung anelliert sind.

Der Alkylrest weist bevorzugt 1 bis 10 C-Atome auf und ist insbesondere ausgewählt aus Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl und n-Heptyl. Besonders bevorzugt ist der Alkylrest ausgewählt aus Methyl, Ethyl und iso-Propyl.

Die aromatische Gruppe kann eine Arylgruppe, eine Heteroarylgruppe oder ein aromatisches Ringsystem sein, bei dem zwei oder mehr Aryl- und/oder Heteroarylgruppen miteinander verknüpft sind, besonders bevorzugt durch Einfachbindungen. Die aromatische Gruppe enthält bevorzugt 6 bis 80 C-Atome. Eine Arylgruppe enthält erfindungsgemäß bevorzugt 6 bis 80 C-Atome. Ein aromatisches Ringsystem mit einer Heteroarylgruppe enthält bevorzugt 2 bis 80 C-Atome und mindestens ein Heteroatom als Ringbestandteil, mit der Maßgabe, dass die Summe aus C-Atomen und Heteroatomen mindestens 5 ergibt. Heteroatome sind bevorzugt ausgewählt aus N, O, S und/oder Se. Unter einer Arylgruppe bzw. Heteroarylgruppe wird entweder ein einfacher aromatischer Cyclus, also Benzol, bzw. ein 6-gliedriger Heteroarylring, wie ein Azin, beispielsweise Pyridin, Pyrimidin, oder Thiophen, oder eine kondensierte (anellierte) Aryl- oder Heteroarylgruppe, beispielsweise Naphthalin, Anthracen, Phenanthren, Chinolin, Isochinolin, etc., verstanden.

Die aromatische Gruppe eines Rests $R_1$, $R_2$ und $R_3$ kann insbesondere mindestens eine Struktureinheit aufweisen, die ausgewählt ist aus Benzol, Naphthalen, Biphenyl, Anthracen, Benzanthracen, Phenanthren, Pyren, Chrysen, Perylen, Fluoranthen, Naphthacen, Pentacen, Benzpyren, Biphenyl, Biphenylen, Terphenyl, Triphenylen, Fluoren, Spirobifluoren, Dihydrophenanthren, Dihydropyren, Tetrahydropyren, cis- oder trans-Indenofluoren, cis- oder trans-Indenocarbazol, cis- oder trans-Indolocarbazol, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Azinen, wie Pyridin, oder Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazo), Phenanthroxazol, Isoxazol, 1,2-Thiazol, 1,3-Thiazol, Benzothiazol, Pyridazin, Hexaazatriphenylen, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol. Die aromatische Gruppe kann mehrere, beispielsweise 2 oder 3, der genannten Struktureinheiten aufweisen, die zueinander identisch oder verschieden sein können. Die Struktureinheiten können über Einfachbindungen miteinander verbunden oder anelliert sein.

Es ist bevorzugt, dass alle aromatischen Ringe der TP-Verbindung entweder ein anelliertes aromatisches System ausbilden oder ein übergeordnetes aromatisches Ringsystem ausbilden, bei dem alle Ringe über Einfachbindungen miteinander verknüpft sind. Die TP-Verbindung weist bevorzugt zwischen 6 bis 20 aromatische Ringe auf oder besteht bevorzugt aus 6 bis 20 aromatischen Ringen. Es hat sich gezeigt, dass bei einer solchen Größe die erfindungsgemäßen Eigenschaften besonders gut erreicht werden.

In einer bevorzugten Ausführungsform bildet die gesamte TP-Verbindung ein konjugiertes System aus. Dies bedeutet, dass keine Substituenten vorhanden sind, die nicht Bestandteil des konjugierten Systems sind.

In einer Ausführungsform der Erfindung ist mindestens ein Rest $R_1$, $R_2$ oder $R_3$ ein Alkylrest $R_5$, ausgewählt aus unverzweigtem Alkyl- mit 1 bis 20 C-Atomen, verzweigtem oder cyclischem Alkyl- mit 3 bis 20 C-Atomen, wobei zwei Reste $R_5$ miteinander verknüpft sein können und einen Ring bilden können. Der Alkylrest weist bevorzugt 1 bis 10 C-Atome auf und ist insbesondere ausgewählt aus Methyl, Ethyl, n-Propyl, i-Propyl, n-Butyl, i-Butyl, s-Butyl, t-Butyl, 2-Methylbutyl, n-Pentyl, s-Pentyl, neo-Pentyl, Cyclopentyl, n-Hexyl, neo-Hexyl, Cyclohexyl und n-Heptyl. Besonders bevorzugt ist der Alkylrest ausgewählt aus Methyl, Ethyl, iso-Propyl und tert-Butyl. Die TP-Verbindung kann einen, zwei oder mehrere solcher Alkylreste aufweisen.

In einer bevorzugten Ausführungsform der Erfindung weist die TP-Verbindung der Formel (1) oder (2) mindestens eine der folgenden Struktureinheiten auf:

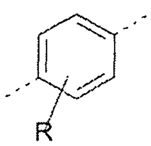 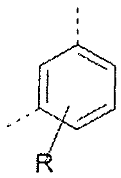 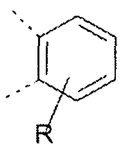

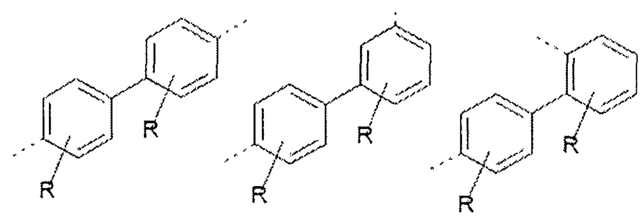

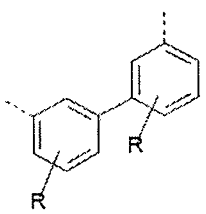 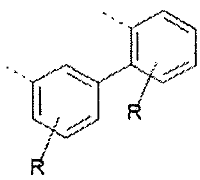 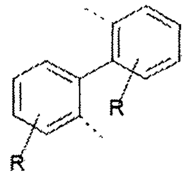

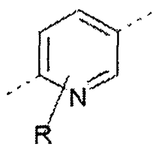 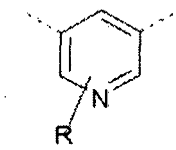 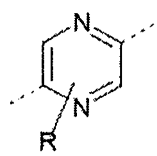 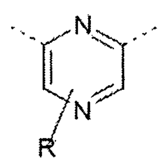 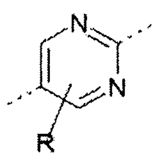

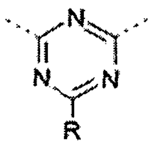 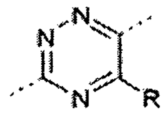 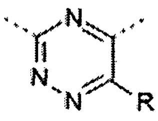

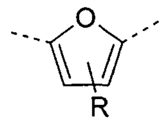 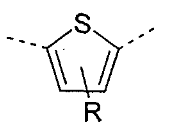 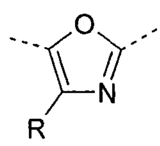 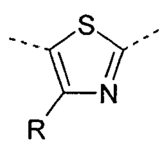

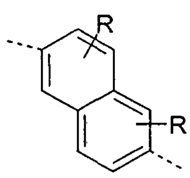 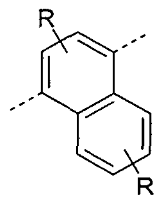 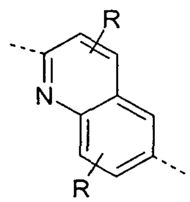 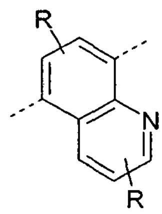

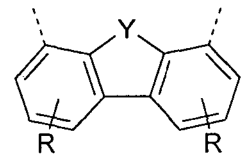 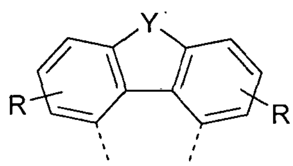

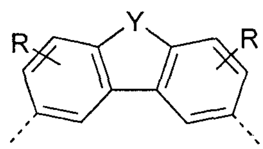 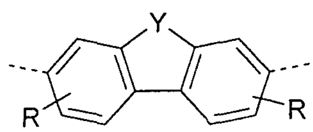

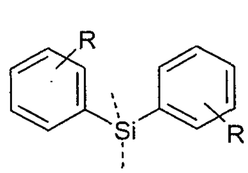

wobei R ausgewählt ist, wie oben für $R_4$ angegeben, oder wobei R eine aromatische Gruppe ist, die mit einem oder mehreren Resten $R_4$ substituiert sein kann,
wobei Y ausgewählt ist aus $C(R_6)_2$, $NR_6$, S, O und Se, wobei $R_6$ ausgewählt ist aus H, unverzweigtem Alkyl mit 1 bis 20 C-Atomen, verzweigtem oder cyclischem Alkyl mit 3 bis 20 C-Atomen, und einer aromatischen Gruppe, die eine Aryl oder Heteroarylgruppe sein kann, insbesondere Phenyl, wobei zwei Reste $R_6$ miteinander verknüpft sein können und einen Ring bilden können. Die gestrichelten Linien stehen für Einfachbindungen, bevorzugt C-C-Einfachbindungen. Die Einfachbindungen betten die Struktureinheiten in die TP-Verbindung ein.

In einer bevorzugten Ausführungsform der Erfindung weist mindestens ein Rest $R_1$, $R_2$ oder $R_3$ eine Struktureinheit auf, die ausgewählt ist aus Benzol, Naphthalen, Biphenyl, Benzofuran, Benzothiophen, Carbazol, Azacarbazol,

Dibenzothiophen, Dibenzofuran, Triphenylen und Azinen, wie Triazin, Pyrimidin und Pyridin.

In einer bevorzugten Ausführungsform der Erfindung weist mindestens ein Rest $R_1$, $R_2$ oder $R_3$ eine Gruppe auf, der elektronenschiebend ist und dabei einen +M-Effekt ausübt. Solche Gruppen oder Reste mit solchen Gruppen werden auch als Donorsubstituenten bezeichnet. Geeignete Donorsubstituenten sind insbesondere Heteroarylgruppen, wie Carbazolgruppen. In einer bevorzugten Ausführungsform ist der Donorsubstituent eine elektronenreiche Heteroarylgruppe, die bevorzugt einen 5-gliedrigen Heterocyclus aufweisen, der bevorzugt genau ein Heteroatom aufweist, das ausgewählt ist aus N, O, S und Se. Insbesondere ist dabei der Rest $R_1$, $R_2$ oder $R_3$ elektronenschiebend und übt einen +M-Effekt aus.

In einer bevorzugten Ausführungsform der Erfindung weist kein Rest $R_1$, $R_2$ oder $R_3$ eine Gruppe auf, die elektronenziehend ist und dabei einen -M-Effekt ausübt. Bei dieser Ausführungsform weist die TP-Verbindung insgesamt keine solche Gruppe auf. Solche Gruppen oder Reste mit solchen Gruppen werden auch als Akzeptorsubstituenten bezeichnet. Akzeptorsubstituenten sind insbesondere Cyanogruppen, aber auch beispielsweise elektronenarme Heteroarylgruppen, die auch weiter substituiert sein können.

In einer bevorzugten Ausführungsform der Erfindung wird eine TP-Verbindung eingesetzt, die mindestens einen Substituenten aufweist, der elektronenschiebend ist und dabei einen +M-Effekt ausübt, und keinen Substituenten aufweist, der elektronenziehend ist und dabei einen -M-Effekt ausübt.

In einer bevorzugten Ausführungsform ist das LUMO der TP-Verbindung kleiner als -2.00 eV.

In einer besonders bevorzugten Ausführungsform ist das LUMO der TP-Verbindung kleiner als -2.70 eV, bevorzugt kleiner -2.80 eV, noch mehr bevorzugt kleiner -2.85 eV. Solche Verbindungen können besonders hohe Effizienzen aufweisen. Solche relativ niedrigen LUMO können erreicht werden, wenn die TP-Verbindung mindestens eine geeignete elektronenziehende Gruppe aufweist, insbesondere eine elektronenarme N-haltige heterocyclische Gruppe, insbesondere eine Azingruppe, wie Pyridin, Pyrimidin oder Triazin.

In einer bevorzugten Ausführungsform weist die Triphenylengruppe oder Azatriphenylengruppe nur anellierte weitere aromatische Ringe auf, die über eine einzige Seite der Ringe mit der Triphenylen- bzw. Azatriphenylengruppe verbunden sind. Bevorzugt sind keine weiteren anellierten Ringe enthalten, die über zwei, drei oder mehr Seiten mit der Triphenylengruppe verbunden sind.

In einer bevorzugten Ausführungsform weist die TP-Verbindung insgesamt 1 bis 8, bevorzugt 1 bis 6 oder 1 bis 4 oder 2 bis 4 Heteroatome auf, wobei sämtliche Heteroatome der TP-Verbindung Ringbestandteile von Heteroarylgruppen sind. Die Heteroatome sind bevorzugt ausgewählt aus N, S und O und bei einer besonders bevorzugten Ausführungsform nur N.

In einer bevorzugten Ausführungsform ist lediglich insgesamt ein einziger Rest $R_1$, $R_2$ oder $R_3$ vorhanden. In einer bevorzugten Ausführungsform weist dieser einzige Rest nur maximal ein einziges Heteroatom auf.

In einer Ausführungsform der Erfindung weist keiner der Reste $R_1$, $R_2$ und $R_3$ der TP-Verbindung eine Heteroarylgruppe aus mindestens fünf anellierten Ringen auf, die mindestens ein N-Atom aufweist und bei der fünf Ringe linear über jeweils eine Ringseite miteinander verbunden sind. Bei dieser Ausführungsform ist die TP-Verbindung insbesondere nicht ein Indenocarbazolderivat oder ein Indolocarbazolderivat. Bei dieser Ausführungsform weist die TP-Verbindung insbesondere nicht eine Heteroarylgruppe aus fünf Ringen auf, bei der einer oder zwei der Ringe Fünfringe mit einem Heteroatom sind und die übrigen Ringe Sechsringe sind.

In einer bevorzugten Ausführungsform weist mindestens einer der Reste $R_1$, $R_2$ oder $R_3$ eine Struktureinheit auf, die ausgewählt ist aus Benzofuran, Benzothiophen, Dibenzofuran und Dibenzothiophen. Dabei ist bevorzugt eines der genannten Strukturelemente über eine C-C-Einfachbindung mit einem Triphenylen verbunden. Dabei kann $R_1$, $R_2$ oder $R_3$ weitere Aryl- oder Heteroarylgruppen aufweisen, die mit dem Benzofuran, Benzothiophen, Dibenzofuran oder Dibenzothiophen über Einfachbindungen verbunden sind. Solche Verbindungen und deren Herstellung werden in der WO 2009/021126 beschrieben. Entsprechende Verbindungen sind beispielhaft unten in den Formeln (25) bis (38) dargestellt.

In einer weiteren bevorzugten Ausführungsform ist die TP-Verbindung eine Verbindung der Formel (1) mit einer Triphenylengruppe, wobei die Reste $R_1$, $R_2$ und $R_3$ ausgewählt sind aus Arylgruppen und aromatischen Ringsystemen aus Arylgruppen. Bei dieser Ausführungsform weist die TP-Verbindung keine Heteroatome auf. Die Arylreste sind bevorzugt Benzolreste. Bevorzugt sind mehrere Benzolreste über Einfachbindungen miteinander verbunden. In einer bevorzugten Ausführungsform ist dabei eine zentrale Triphenylengruppe insgesamt mit zwei bis zehn Benzolgruppen, bevorzugt drei bis sechs Benzolresten substituiert. Entsprechende Verbindungen werden in der WO 2009/021107 A2 beschrieben. Entsprechende Verbindungen sind beispielhaft unten in den Formeln (17) bis (24) dargestellt.

Weitere Triphenylenverbindungen, bei denen eine zentrale Triphenylgruppe ausschließlich mit Arylresten substituiert ist, werden in der WO 2006/130598 A2 offenbart. Entsprechende Verbindungen sind beispielhaft unten in den Formeln (3a), (3b) und (4) bis (16) gezeigt. In einer Ausführungsform weisen die Reste $R_1$, $R_2$ und $R_3$ Naphthalengruppen auf. In einer Ausführungsform weisen die Reste $R_1$, $R_2$ und/oder $R_3$ Alkarylgruppen auf. Dabei weisen die Alkylgruppen bevorzugt 1 bis 10 Kohlenstoffatome auf. Beispielhaft ist unten die Verbindung der Formel (6) dargestellt. In einer bevorzugten Ausführungsform weist die TP-Verbindung zwei oder mehr Triphenylen-Struktureinheiten auf. Entsprechende Verbindungen sind beispielhaft in den Formeln (7) bis (13) und (16) dargestellt. In einer bevorzugten Ausführungsform besteht die TP-Verbindung aus Triphenylen-Strukturelementen. In einer besonderen Ausführungsform weist die Triphenylenverbindung mindestens einen anellierten Benzolrest auf, der mit der Triphenylengruppe über eine Ringkante verbunden ist. Solche Verbindungen enthalten ein Chrysen-Strukturelement oder ein höherwertiges Strukturelement, wie Picen. Solche Verbindungen sind beispielhaft in den Formeln (14) und (15) dargestellt.

In einer bevorzugten Ausführungsform ist die TP-Verbindung eine Verbindung der oben genannten Formel (2), die eine zentrale Azatriphenylengruppe aufweist. In einer bevorzugten Ausführungsform weist diese TP-Verbindung insgesamt nur einen einzigen Substituenten $R_1$, $R_2$ und $R_3$ auf. Der Rest $R_1$, $R_2$ oder $R_3$ kann dabei ein Aryl- oder Heteroarylrest sein oder ein aromatisches Ringsystem mit mehreren über Einzelbindungen verbundenen Aryl- oder Heteroarylgruppen. Der Rest $R_1$, $R_2$ oder $R_3$ kann in $\alpha$-Position zum N der Azatriphenylengruppe substituiert sein. Solche Verbindungen werden beispielsweise in der WO 2010/132524 A1 offenbart. Entsprechende Verbindungen sind beispielhaft in den Formeln (39) bis (58) dargestellt.

In einer weiteren bevorzugten Ausführungsform weist die TP-Verbindung mindestens eine Struktureinheit auf, die ausgewählt ist aus Benzofuran, Benzothiophen, Benzoselenophen, Dibenzofuran, Dibenzothiophen oder Dibenzoselenophen. Die genannten Verbindungen können weitere aromatische Ringe aufweisen, die mit einer der genannten Gruppen anelliert sind. Die Struktureinheit kann beispielsweise aus vier anellierten Ringen bestehen. Solche Verbindungen werden in der WO 2011/137157 A1 beschrieben. Entsprechende Verbindungen sind unten in den Formeln (59) bis (68) dargestellt. In einer Ausführungsform weist keiner der Reste $R_1$, $R_2$ oder $R_3$ fünf anellierte Ringe auf.

In einer weiteren bevorzugten Ausführungsform weist eine TP-Verbindung der Formel (1) mehrere, insbesondere vier, identische Substituenten $R_1$ auf. Dabei ist $R_1$ insbesondere ein Phenylrest, der über eine C-C-Einfachbindung mit dem zentralen Triphenylen verbunden ist. Die Verbindung weist bevorzugt zusätzlich jeweils einen Substituenten $R_2$ und $R_3$ auf, die bevorzugt identisch zueinander sind. Die Substituenten $R_2$ und $R_3$ können beispielsweise Aryl- oder Heteroarylgruppen sein. Solche Verbindungen werden in der WO 2009/037155 A1 offenbart. Entsprechende Verbindungen sind beispielhaft unten in den Formeln (69) bis (71) dargestellt.

In einer weiteren, besonders bevorzugten, Ausführungsform weist die Verbindung der Formel (1) ein Strukturelement auf, das eine Carbazolgruppe, Azacarbazolgruppe oder Diazacarbazolgruppe ist. In einer bevorzugten Ausführungsform sind ausschließlich Reste $R_1$, $R_2$ und $R_3$ vorhanden, die eine Carbazolgruppe, Azacarbazolgruppe oder Diazacarbazolgruppe aufweisen. Dabei sind bevorzugt nur einer oder zwei dieser Substituenten vorhanden. Es kann der Rest $R_1$, $R_2$ oder $R_3$ aus der Carbazolgruppe, Azacarbazolgruppe oder Diazacarbazolgruppe bestehen. Bevorzugt ist der Rest über das N-Atom des 5-Rings mit der Triphenylengruppe verbunden. Entsprechende Verbindungen werden in der JP 2006/143845 offenbart. Entsprechende Verbindungen sind beispielhaft unten in den Formeln (72) bis (81) dargestellt.

In einer weiteren bevorzugten Ausführungsform der Erfindung weist die TP-Verbindung mindestens zwei, insbesondere genau zwei, Triphenylengruppen auf, die über eine Heteroarylgruppe oder ein aromatisches Ringsystem, das eine Heteroarylgruppe aufweist, verbunden sind. Dabei sind die Triphenylengruppen mit den Heteroarylgruppen oder dem aromatischen Ringsystem bevorzugt über Einfachbindungen verbunden. Die Heteroarylgruppe kann dabei insbesondere eine N-haltige Heteroarylgruppe sein, insbesondere ein Azin, wie Pyridin, Pyrimidin oder Triazin, oder Carbazol. Solche Verbindungen werden in der KR 2011/0041729 offenbart. Entsprechende Verbindungen sind beispielhaft unten in den Formeln (82) bis (91) dargestellt.

In einer weiteren bevorzugten Ausführungsform weist die TP-Verbindung eine einzige Triphenylenstruktureinheit auf, die mit einem einzigen Rest substituiert ist. Dabei weist der Rest eine aromatische Struktureinheit auf, die mindestens eine nicht anellierte Arylgruppe, insbesondere eine Benzolgruppe, und mindestens eine nicht anellierte N-haltige Heteroarylgruppe, insbesondere Carbazol oder Indol, enthält. Bevorzugt weist das aromatische Ringsystem dabei vier bis acht Ringe auf. Eine Arylgruppe kann mit einem Halogenatom substituiert sein. Solche Verbindungen werden in der WO 2011/081423 offenbart. Entsprechende Verbindungen sind beispielhaft durch die Formeln (92) bis (100) dargestellt.

In einer weiteren bevorzugten Ausführungsform weist die TP-Verbindung eine einzige Triphenylengruppe auf, die mit mindestens einem Rest substituiert ist, der Anthracen ist, bei dem mindestens ein C-H durch ein Heteroatom ersetzt ist. Insbesondere ist das Strukturelement ein Dithia-anthracen oder Thia-oxa-anthracen. Besonders bevorzugt ist die Struktureinheit ein 9,10-Dithia-anthracen oder 9-Oxa-10-thia-anthracen. Entsprechende Verbindungen werden in der WO 2011/081451 A1 offenbart. Entsprechende Verbindungen sind beispielhaft in den Formeln (101) bis (108) dargestellt. Die Verbindungen weisen bevorzugt insgesamt nur einen einzigen Substituenten $R_1$, $R_2$ oder $R_2$ auf. Die Verbindung kann einen Halogensubstituenten aufweisen.

In einer bevorzugten Ausführungsform der Erfindung weist einer der Reste $R_1$, $R_2$ oder $R_3$ eine Carbazolgruppe auf, die mindestens einen weiteren anellierten Ring aufweist. Die Carbazolgruppe weist somit mindestens vier Ringe auf. Dabei ist es bevorzugt, dass die Carbazolgruppe fünf Ringe aufweist, die jeweils über eine Ringseite verknüpft sind, wobei die Carbazolgruppe mit einem äußeren aromatischen Ring über einen vierten Ring verbunden ist, der nicht aromatisch ist. Bevorzugt weist eine solche TP-Verbindung insgesamt nur einen einzigen Substituenten $R_1$, $R_2$ oder $R_3$

auf. Bevorzugt weist diese Verbindung eine einzige Triphenylengruppe auf, die über eine Einfachbindung mit der Carbazolgruppe verbunden ist. Die Bindung kann zu dem N-Atom der Carbazolgruppe erfolgen. Solche Verbindungen und deren Herstellung werden in der WO 2013/056776 beschrieben. Entsprechende Verbindungen sind beispielhaft unten in den Formeln (121) bis (154) dargestellt. Alternativ kann die Verbindung eine einzige Triphenylengruppe aufweisen, die über eine aromatische Ringstruktur mit der Carbazolgruppe verbunden ist. Dabei können zwischen der Triphenylengruppe und der Carbazolgruppe eine oder mehrere Aryl- oder Heteroarylreste positioniert sein, zum Beispiel eine Benzylgruppe oder Biphenylgruppe. Bevorzugt weist eine solche TP-Verbindung insgesamt nur einen einzigen Substituenten $R_1$, $R_2$ oder $R_3$ auf. Solche Verbindungen und deren Herstellung werden in der WO 2012/039561 A1 beschrieben. Entsprechende Verbindungen sind beispielhaft unten in den Formeln (109) bis (120) dargestellt.

In bevorzugten Ausführungsformen der Erfindung ist die TP-Verbindung eine Verbindung der folgenden Formeln (3a) bis (154):

| | |
|---|---|
| 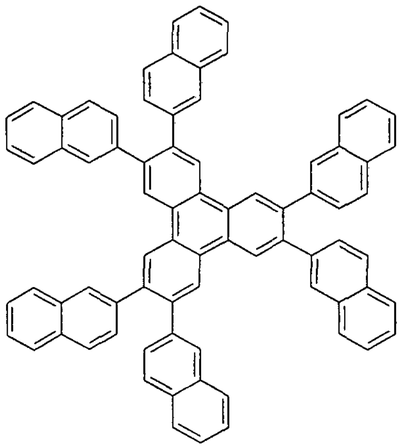 | 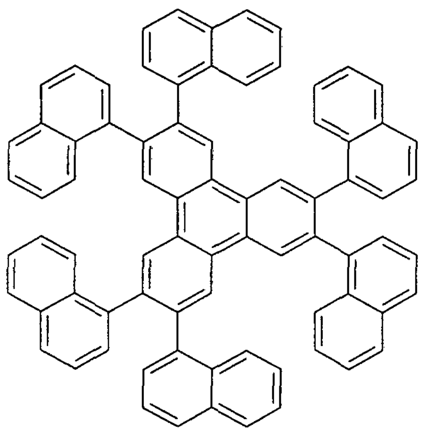 |
| (3a) | (3b) |
| 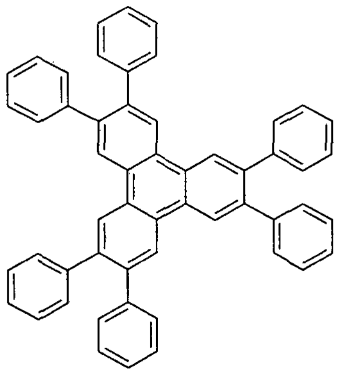 | 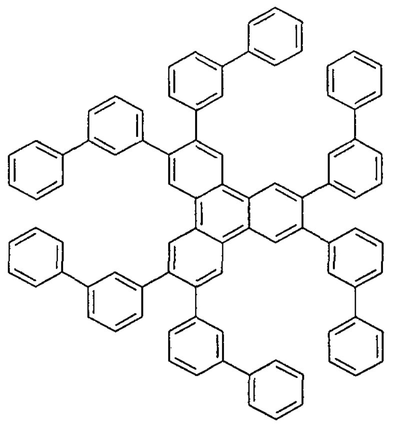 |
| (3c) | (4) |

(fortgesetzt)

| | |
|---|---|
| 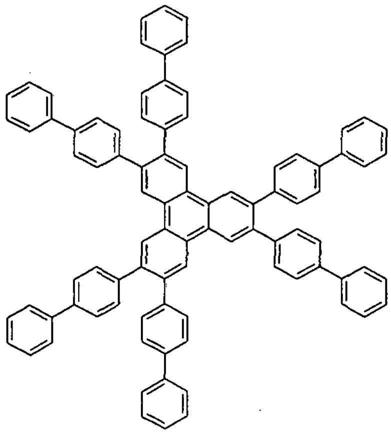 | 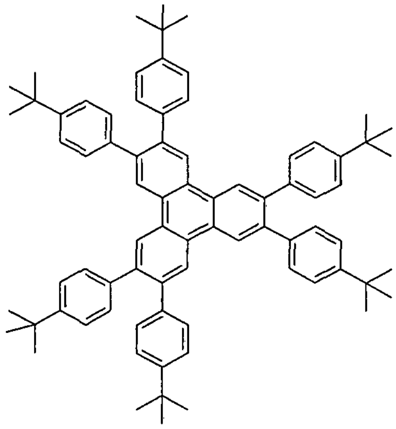 |
| (5) | (6) |
| 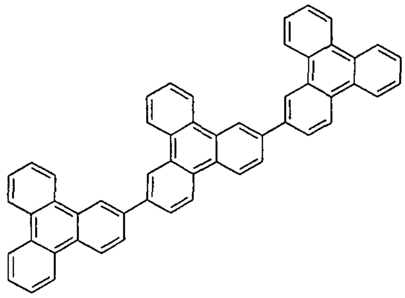 | 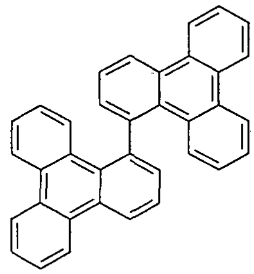 |
| (7) | (8) |
| 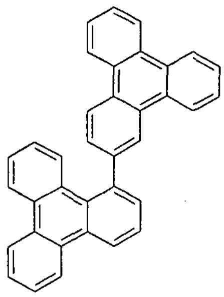 | 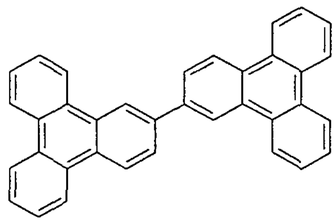 |
| (9) | (10) |
| 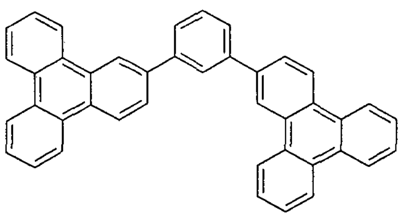 | 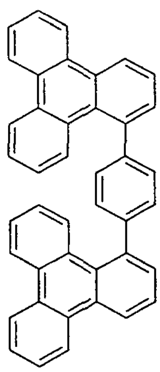 |
| (11) | (12) |

(fortgesetzt)

| | |
|---|---|
| 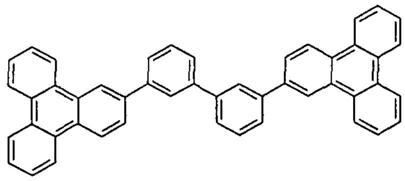 | 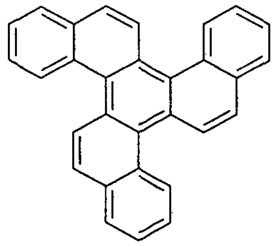 |
| (13) | (14) |
| 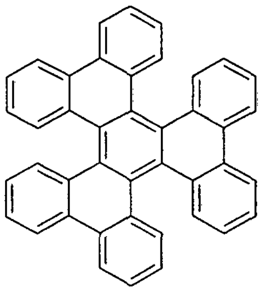 | 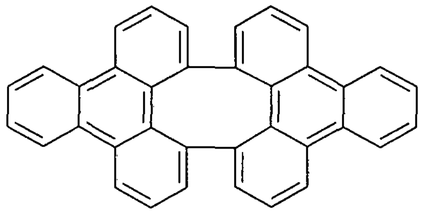 |
| (15) | (16) |
| 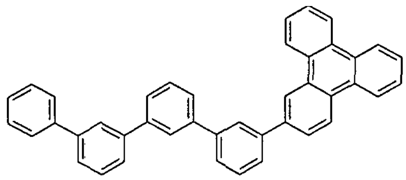 | 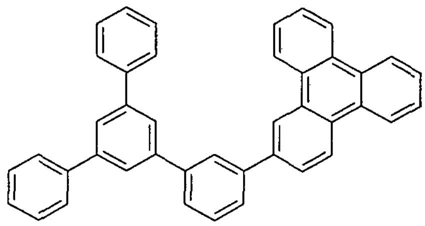 |
| (17) | (18) |
| 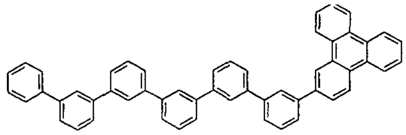 | 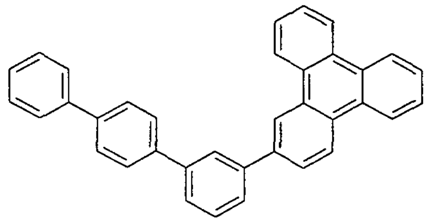 |
| (19) | (20) |
| 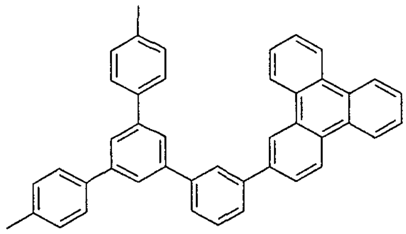 | 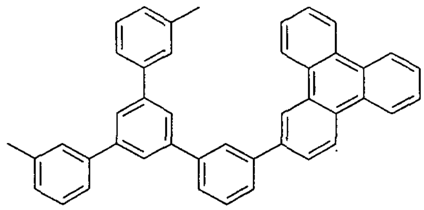 |
| (21) | (22) |

(fortgesetzt)

| | |
|---|---|
| 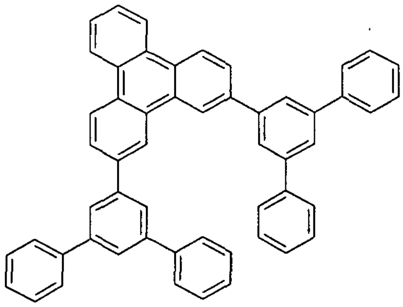 | 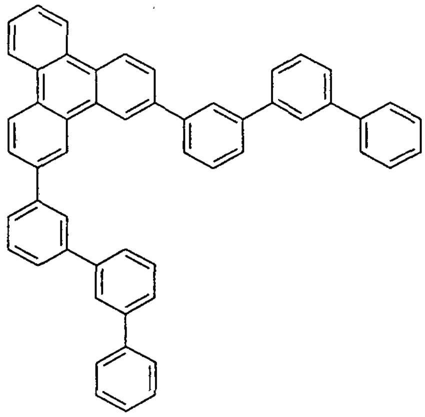 |
| (23) | (24) |
| 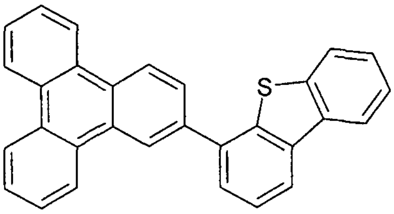 | 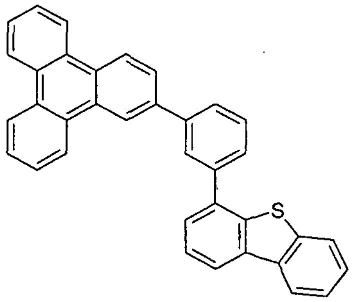 |
| (25) | (26) |
| 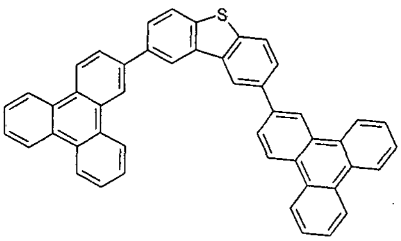 | 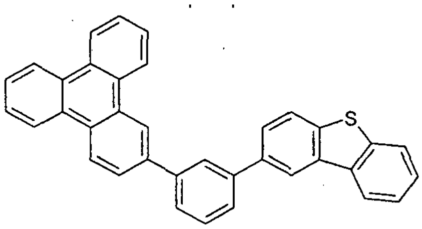 |
| (27) | (28) |
| 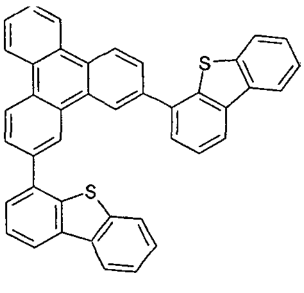 | 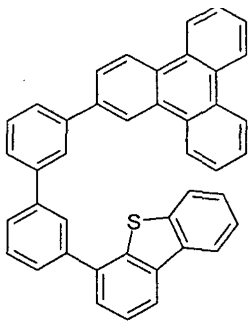 |
| (29) | (30) |

(fortgesetzt)

| | |
|---|---|
| 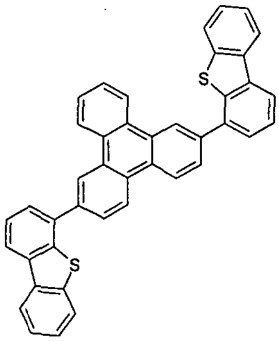 | 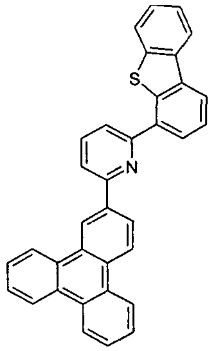 |
| (31) | (32) |
| 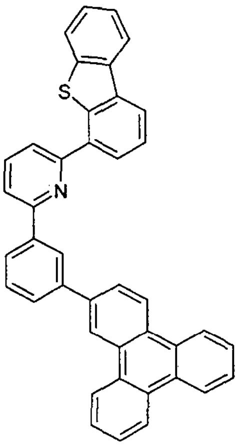 | 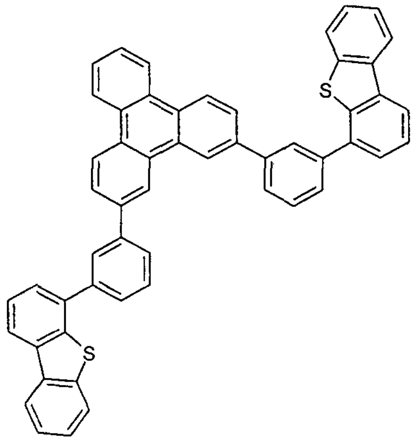 |
| (33) | (34) |
| 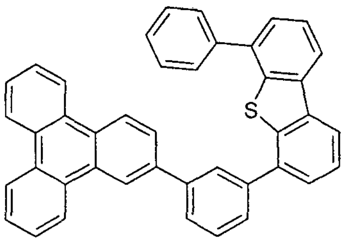 | 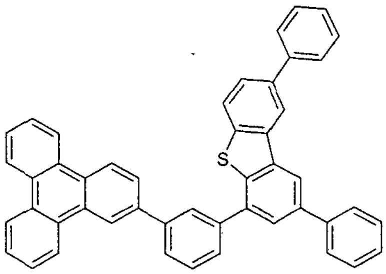 |
| (35) | 36 |
| 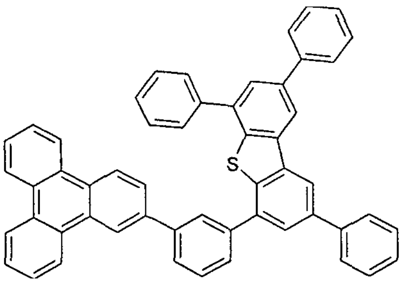 | 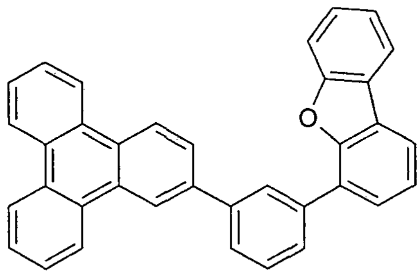 |
| (37) | (38) |

(fortgesetzt)

| | |
|---|---|
| 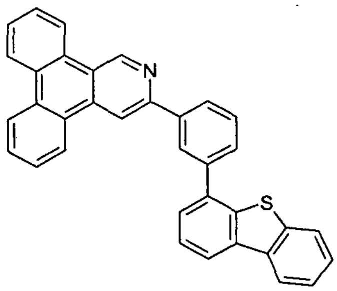 | 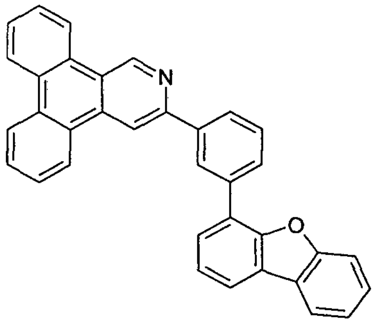 |
| (39) | (40) |
| 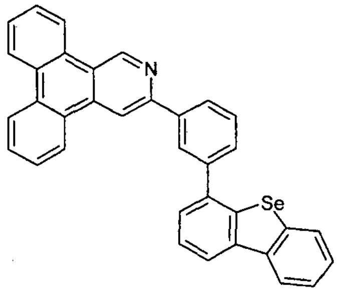 | 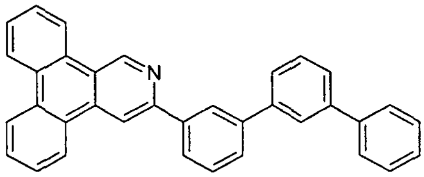 |
| (41) | (42) |
| 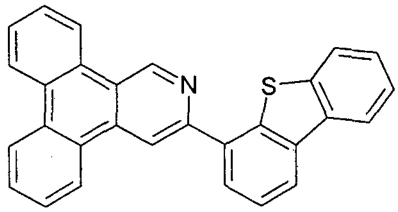 | 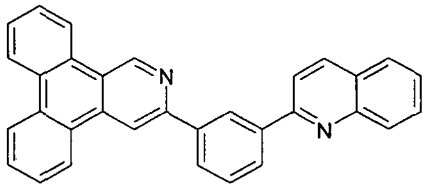 |
| (43) | (44) |
| 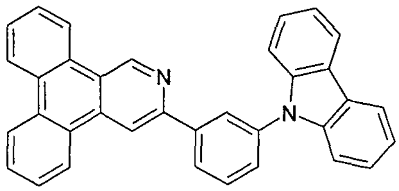 | 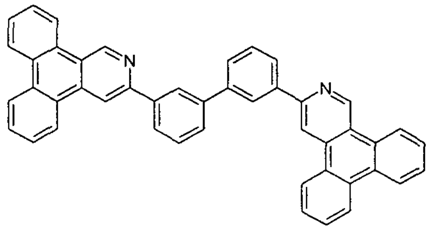 |
| (45) | (46) |
| 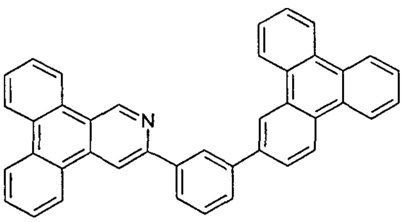 | 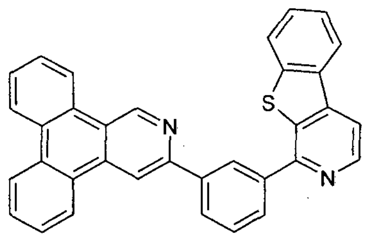 |
| (47) | (48) |

(fortgesetzt)

| | |
|---|---|
| 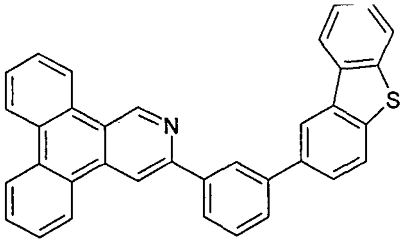 | 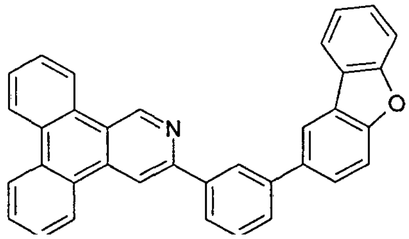 |
| (49) | (50) |
| 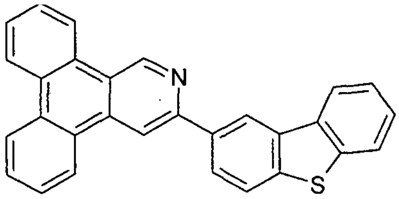 | 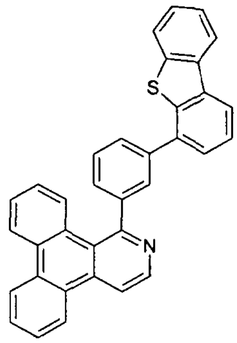 |
| (51) | (52) |
| 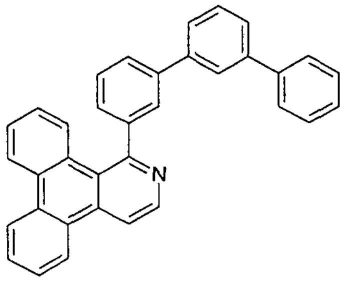 | 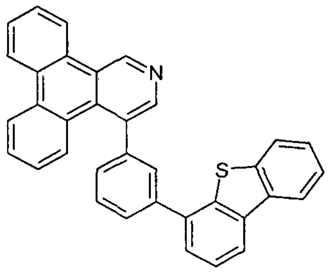 |
| (53) | (54) |
| 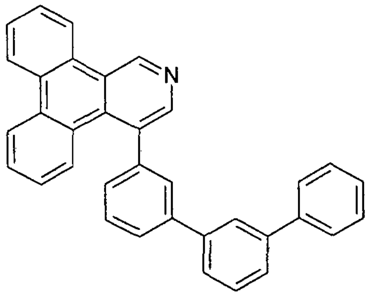 | 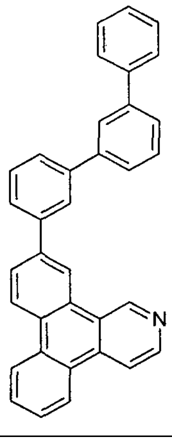 |
| (55) | (56) |

(fortgesetzt)

| | |
|---|---|
| 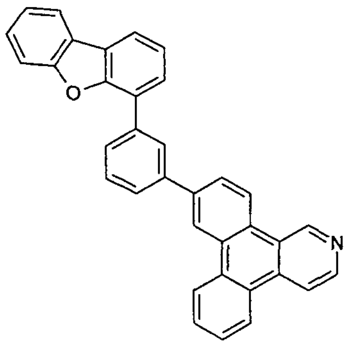 | 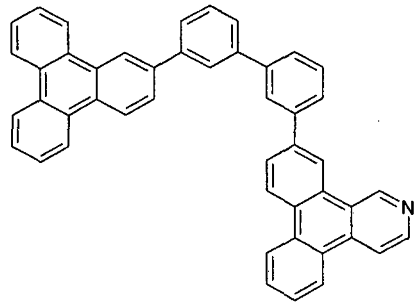 |
| (57) | (58) |
| 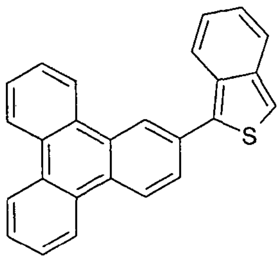 | 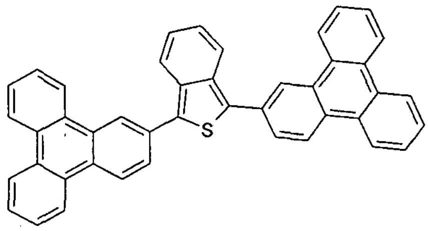 |
| (59) | (60) |
| 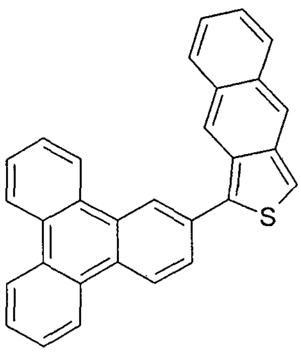 | 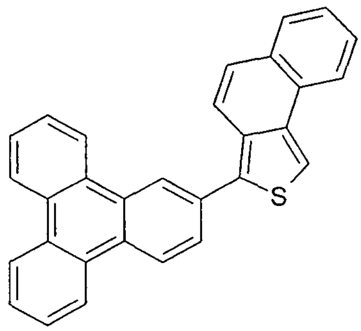 |
| (61) | (62) |
| 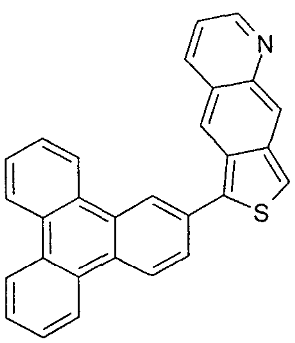 | 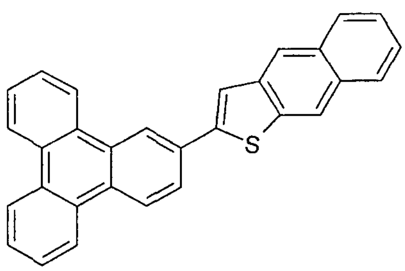 |
| (63) | (64) |

(fortgesetzt)

| | |
|---|---|
| 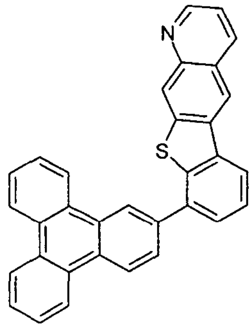 | 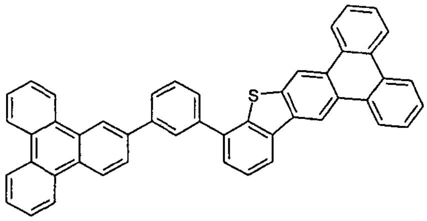 |
| (65) | (66) |
| 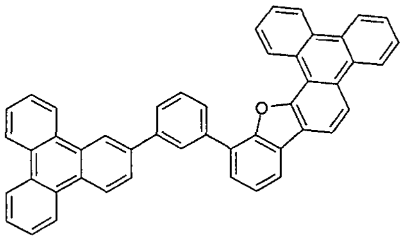 | 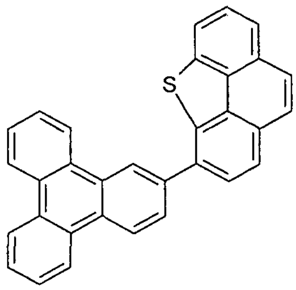 |
| (67) | (68) |
| 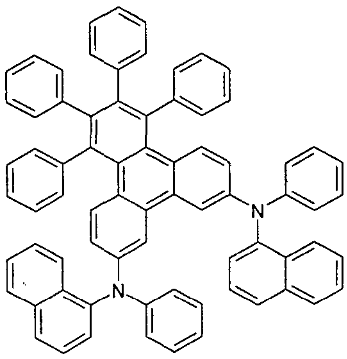 | 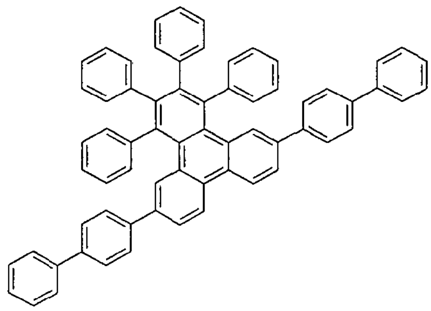 |
| (69) | (70) |
| 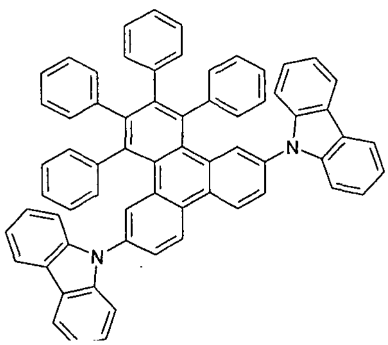 | 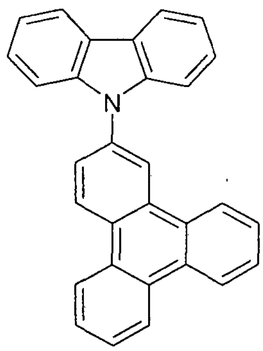 |
| (71) | (72) |

(fortgesetzt)

| | |
|---|---|
| 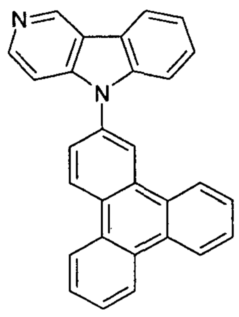 | 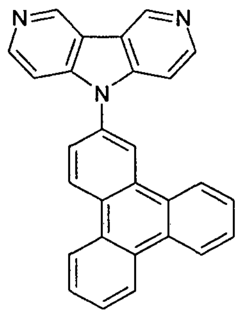 |
| (73) | (74) |
| 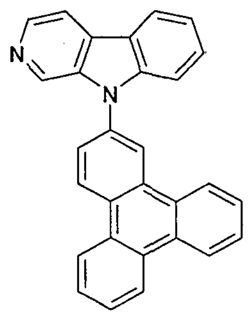 | 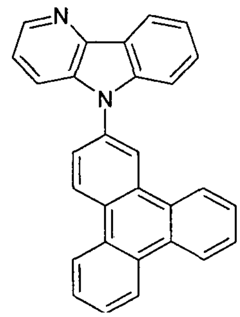 |
| (75) | (76) |
| 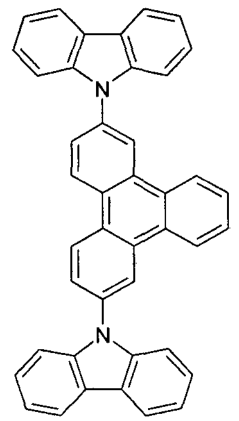 | 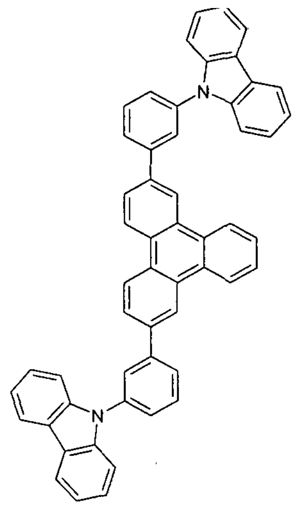 |
| (77) | (78) |

(fortgesetzt)

| | |
|---|---|
| 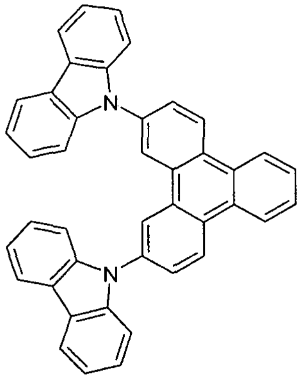 | 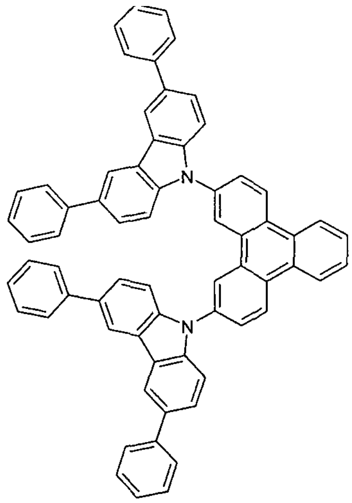 |
| (79) | (80) |
| 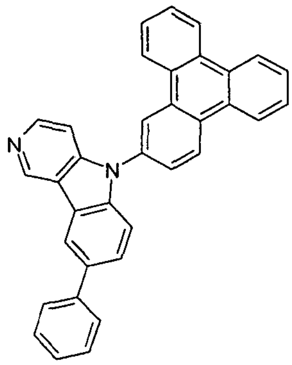 | 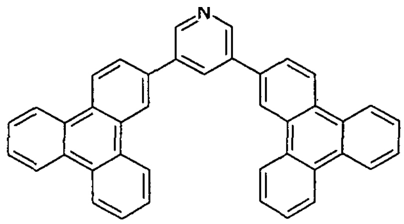 |
| (81) | (82) |
| 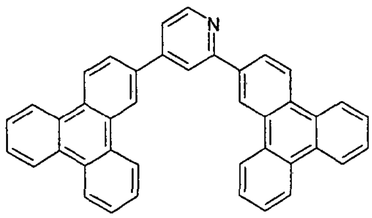 | 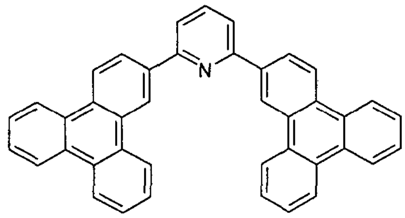 |
| (83) | (84) |
| 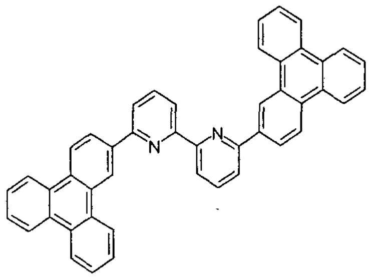 | 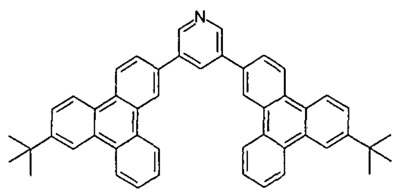 |
| (85) | (86) |

(fortgesetzt)

| | |
|---|---|
| 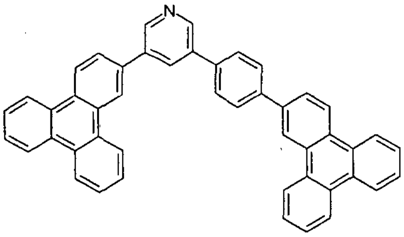 | 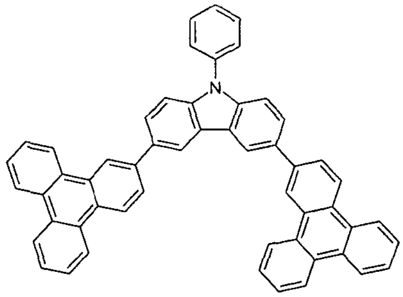 |
| (87) | (88) |
| 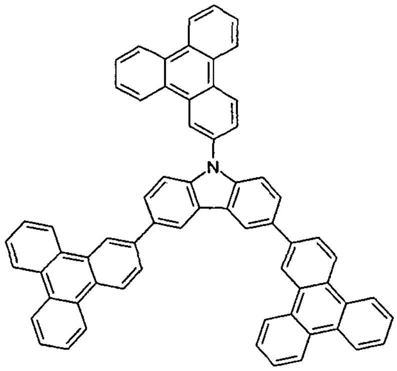 | 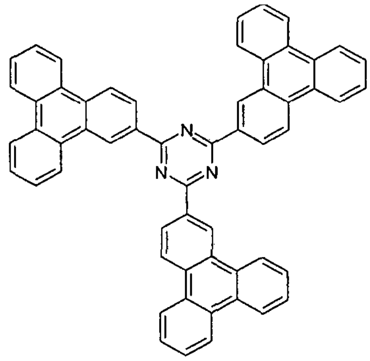 |
| (89) | (90) |
| 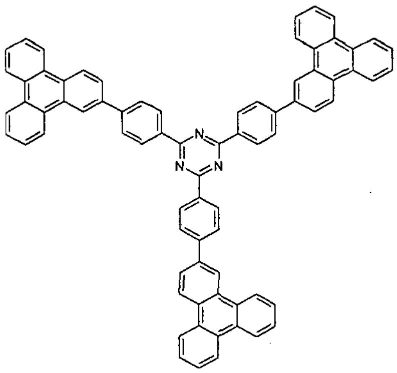 | 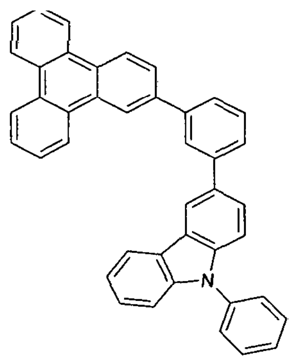 |
| (91) | (92) |
| 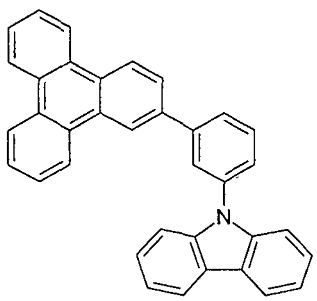 | 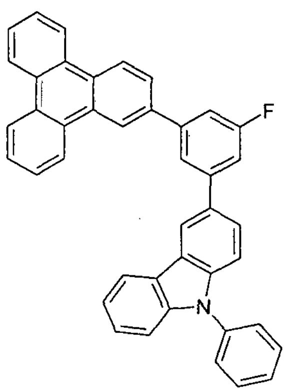 |
| (93) | (94) |

(fortgesetzt)

| | |
|---|---|
| 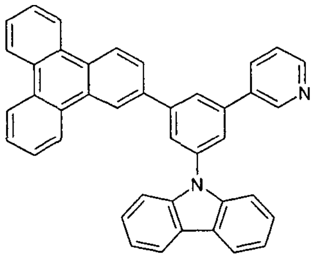 | 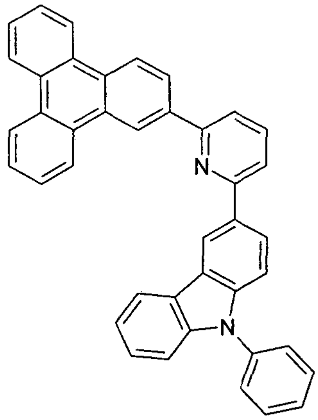 |
| (95) | (96) |
| 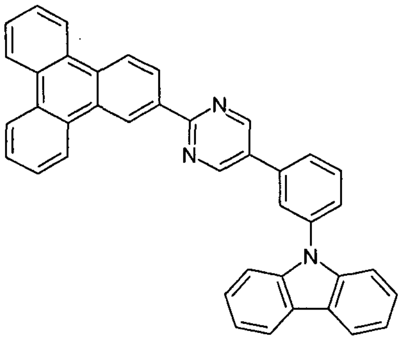 | 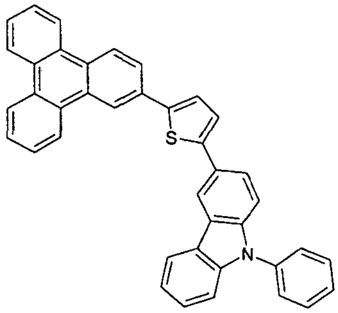 |
| (97) | (98) |
| 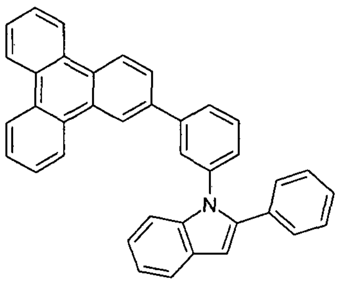 | 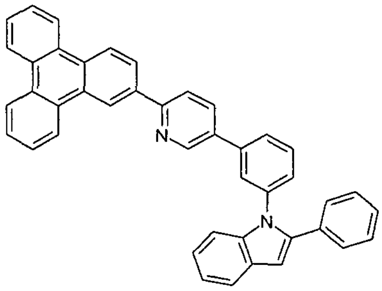 |
| (99) | (100) |
| 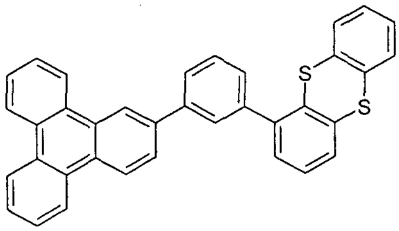 | 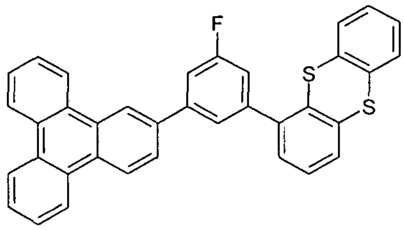 |
| (101) | (102) |

(fortgesetzt)

| | |
|---|---|
| 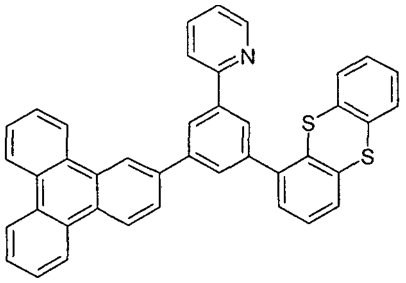 | 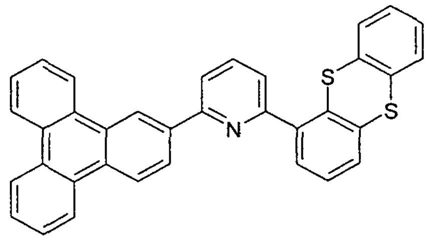 |
| (103) | (104) |
| 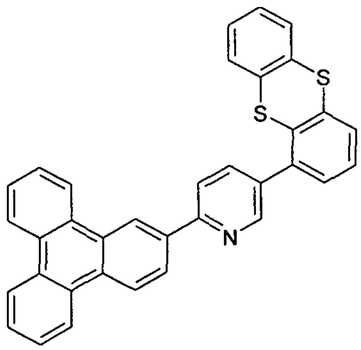 | 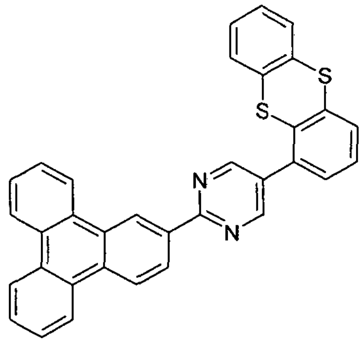 |
| (105) | (106) |
| 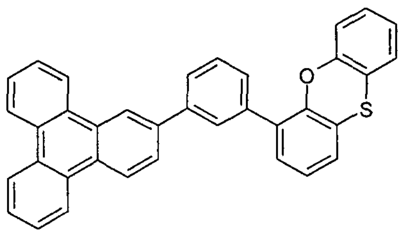 | 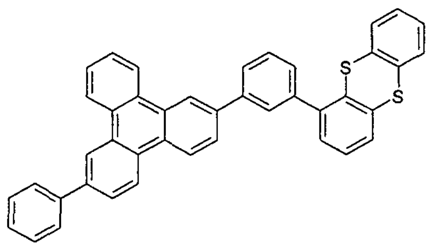 |
| (107) | (108) |
| 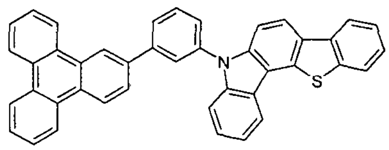 | 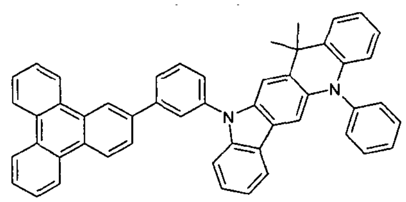 |
| (109) | (110) |
| 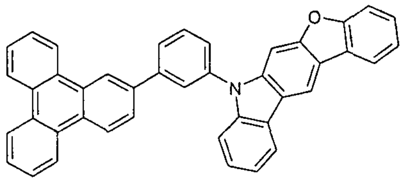 | 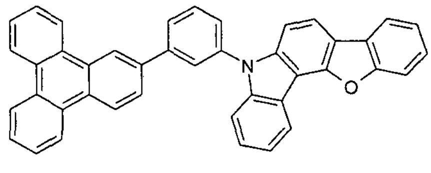 |
| (111) | (112) |

(fortgesetzt)

| | |
|---|---|
| 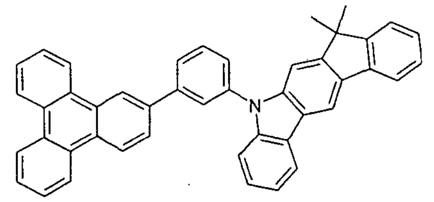 | 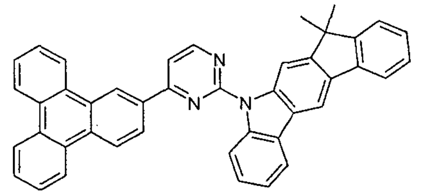 |
| (113) | (114) |
| 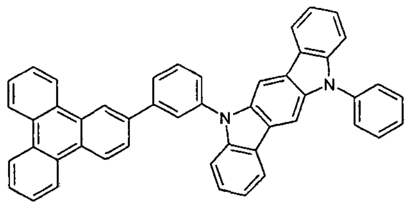 | 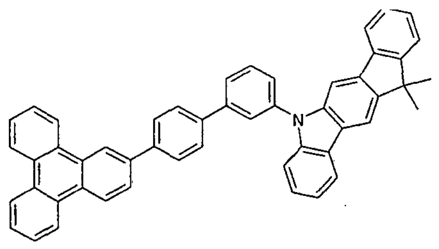 |
| (115) | (116) |
| 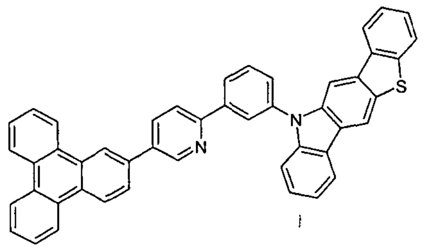 | 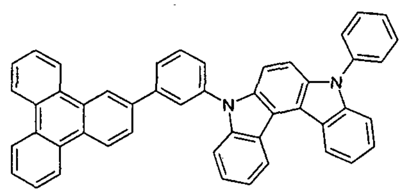 |
| (117) | (118) |
| 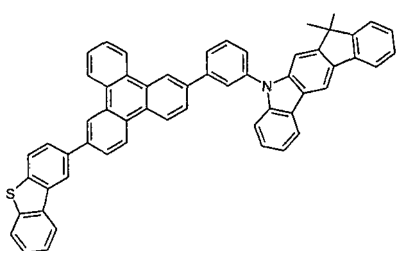 | 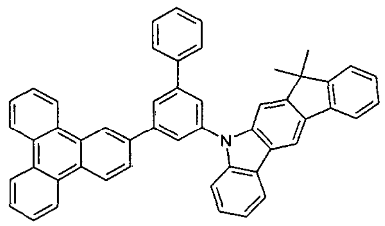 |
| (119) | (120) |
| 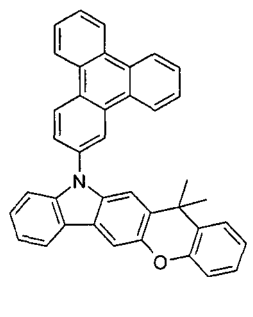 | 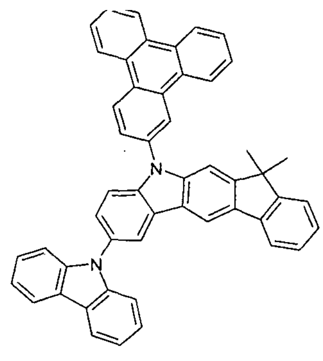 |
| (121) | (122) |

(fortgesetzt)

| | |
|---|---|
| 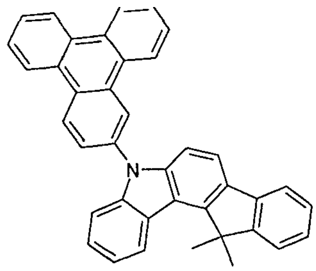 | 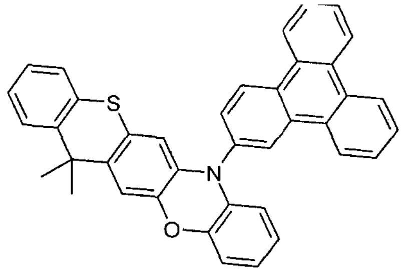 |
| (123) | (124) |
| 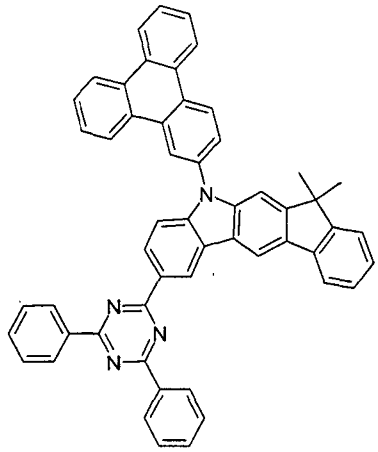 | 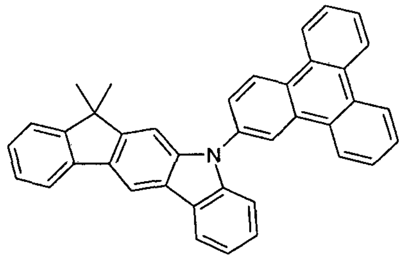 |
| (125) | (126) |
| 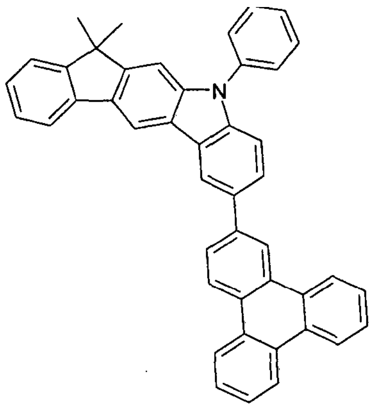 | 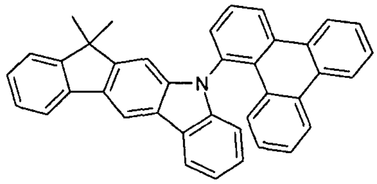 |
| (127) | (128) |
| 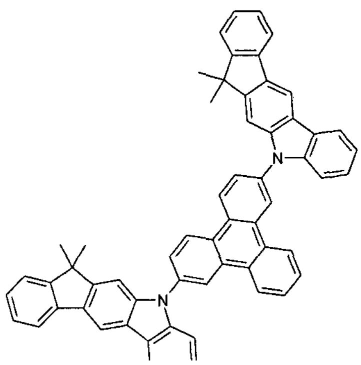 | 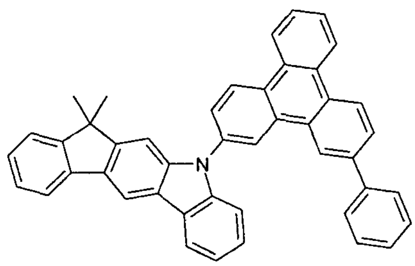 |
| (129) | (130) |

(fortgesetzt)

| | |
|---|---|
| 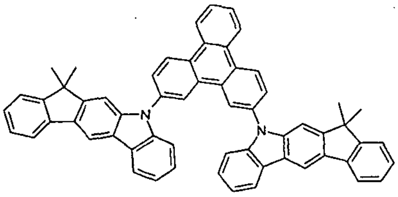 | 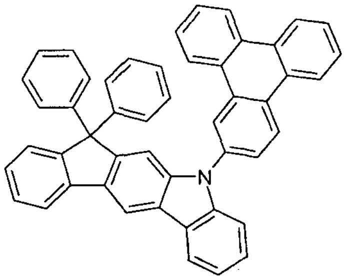 |
| (131) | (132) |
| 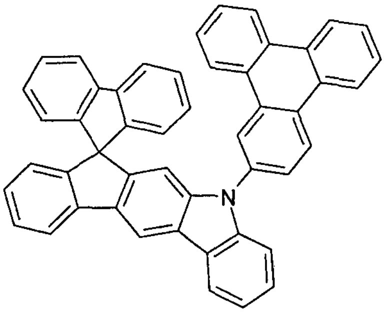 | 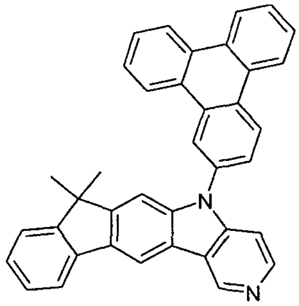 |
| (133) | (134) |
| 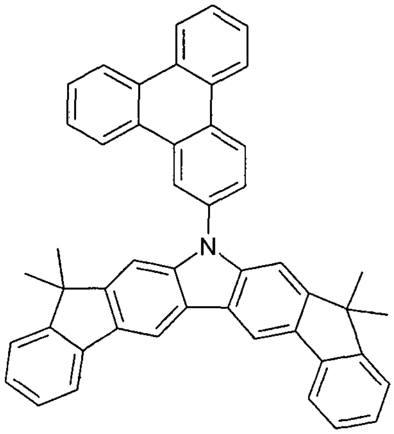 | 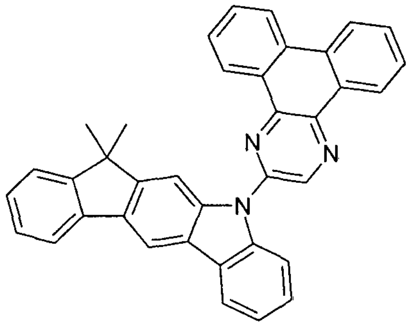 |
| (135) | (136) |
| 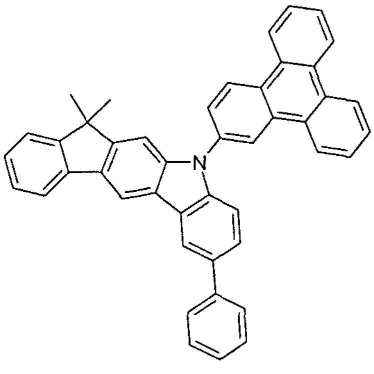 | 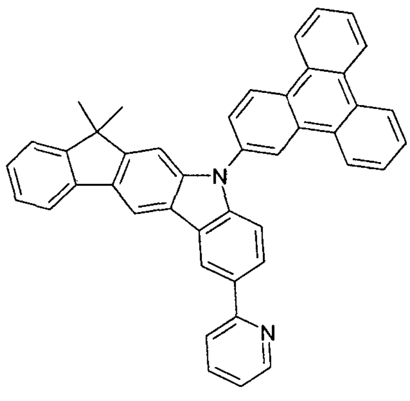 |
| (137) | (138) |

(fortgesetzt)

| | |
|---|---|
| 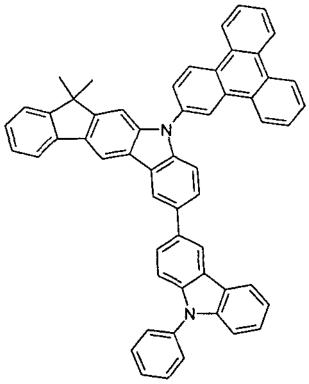 | 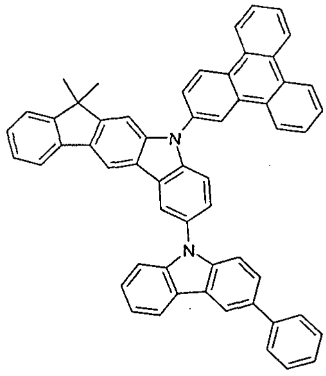 |
| (139) | (140) |
| 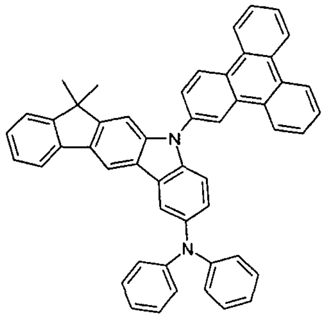 | 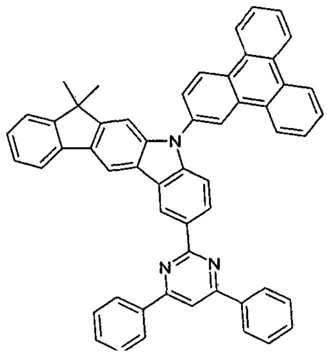 |
| (141) | (142) |
| 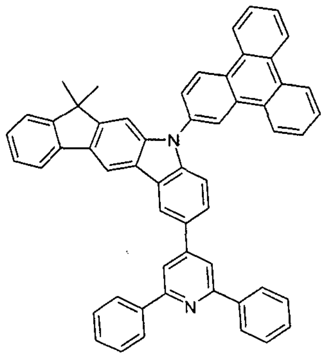 | 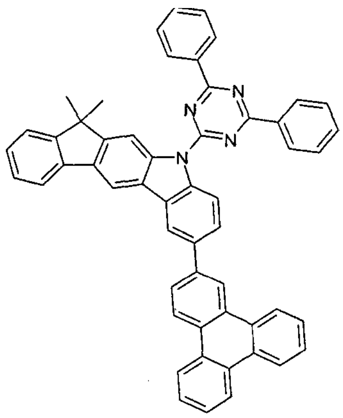 |
| (143) | (144) |
| 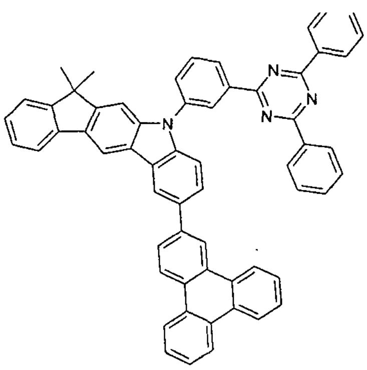 | 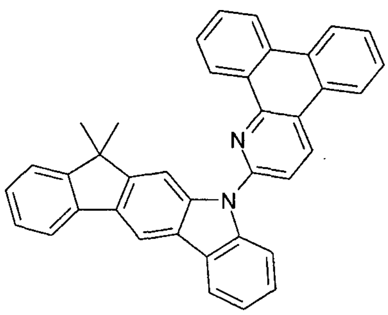 |

(fortgesetzt)

| | |
|---|---|
| (145) | (146) |
| 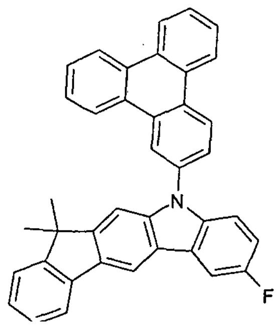 | 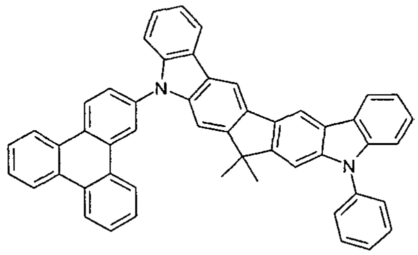 |
| (147) | (148) |
| 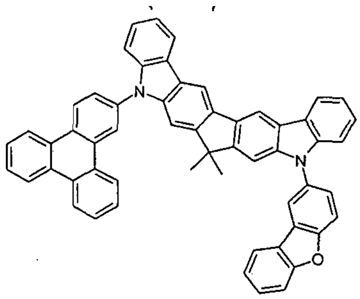 | 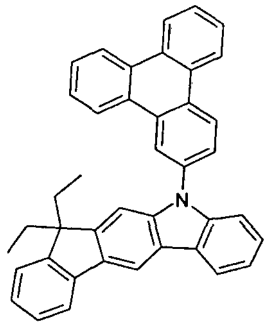 |
| (149) | (150) |
| 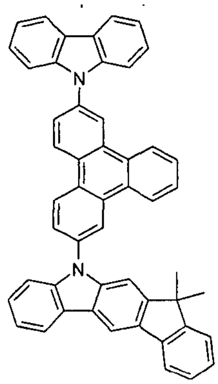 | 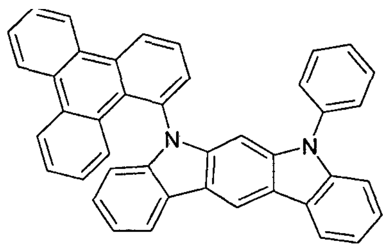 |
| (151) | (152) |
| 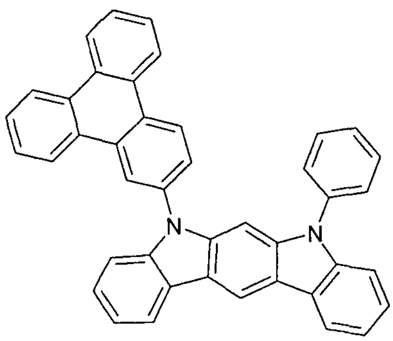 | 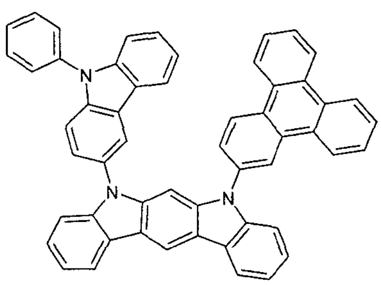 |
| (153) | (154) |

Im Folgenden wird die organische Elektrolumineszenzvorrichtung näher beschrieben.

Die organische Elektrolumineszenzvorrichtung enthält Kathode, Anode und eine emittierende Schicht. Außer diesen Schichten kann sie noch weitere Schichten enthalten, beispielsweise jeweils eine oder mehrere Lochinjektionsschichten, Lochtransportschichten, Lochblockierschichten, Elektronentransportschichten, Elektroneninjektionsschichten, Exzitonenblockierschichten, Elektronenblockierschichten und/oder Ladungserzeugungsschichten (Charge-Generation Layers). Es sei aber darauf hingewiesen, dass nicht notwendigerweise jede dieser Schichten vorhanden sein muss.

In den weiteren Schichten der erfindungsgemäßen organischen Elektrolumineszenzvorrichtung, insbesondere in den Lochinjektions- und -transportschichten und in den Elektroneninjektions- und -transportschichten, können alle Materialien verwendet werden, wie sie üblicherweise gemäß dem Stand der Technik eingesetzt werden. Dabei können die Lochtransportschichten auch p-dotiert bzw. die Elektronentransportschichten auch n-dotiert sein. Dabei wird unter einer p-dotierten Schicht eine Schicht verstanden, in der freie Löcher erzeugt werden und deren Leitfähigkeit dadurch erhöht ist. Eine umfassende Diskussion von dotierten Transportschichten in OLEDs findet sich in Chem. Rev. 2007, 107, 1233. Besonders bevorzugt ist der p-Dotand in der Lage, das Lochtransportmaterial in der Lochtransportschicht zu oxidieren, hat also ein ausreichend hohes Redoxpotential, insbesondere ein höheres Redoxpotential als das Lochtransportmaterial. Als Dotanden sind prinzipiell alle Verbindungen geeignet, welche Elektronenakzeptorverbindungen darstellen und die Leitfähigkeit der organischen Schicht durch Oxidation des Hosts erhöhen können. Der Fachmann kann im Rahmen seines allgemeinen Fachwissens ohne größeren Aufwand geeignete Verbindungen identifizieren. Insbesondere geeignet als Dotanden sind die in WO 2011/073149, EP 1968131, EP 2276085, EP 2213662, EP 1722602, EP 2045848, DE 102007031220, US 8044390, US 8057712, WO 2009/003455, WO 2010/094378, WO 2011/120709 und US 2010/0096600 offenbarten Verbindungen.

Der Fachmann kann daher ohne erfinderisches Zutun alle für organische Elektrolumineszenzvorrichtungen bekannten Materialien in Kombination mit der erfindungsgemäßen emittierenden Schicht einsetzen.

Als Kathode sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lathanoide (z. B. Ca, Ba, Mg, Al, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag, wobei dann in der Regel Kombinationen der Metalle, wie beispielsweise Ca/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, $Li_2O$, $BaF_2$, MgO, NaF, CsF, $CS_2CO_3$, etc.). Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektronen (z. B. Al/Ni/$NiO_x$, Al/PtOx) bevorzugt sein. Dabei muss mindestens eine der Elektroden transparent oder teiltransparent sein, um die Auskopplung von Licht zu ermöglichen. Ein bevorzugter Aufbau verwendet eine transparente Anode. Bevorzugte Anodenmaterialien sind hier leitfähige gemischte Metalloxide. Besonders bevorzugt sind Indium-Zinn-Oxid (ITO) oder Indium-Zink Oxid (IZO). Bevorzugt sind weiterhin leitfähige, dotierte organische Materialien, insbesondere leitfähige dotierte Polymere.

Die Vorrichtung wird entsprechend (je nach Anwendung) strukturiert, kontaktiert und schließlich hermetisch versiegelt, da sich die Lebensdauer derartiger Vorrichtungen bei Anwesenheit von Wasser und/oder Luft drastisch verkürzt.

Weiterhin bevorzugt ist eine organische Elektrolumineszenzvorrichtung, wobei eine oder mehrere Schichten mit einem Sublimationsverfahren beschichtet werden. Dabei werden die Materialien in Vakuum-Sublimationsanlagen bei einem Anfangsdruck kleiner $10^{-5}$ mbar, bevorzugt kleiner $10^{-6}$ mbar aufgedampft. Es ist aber auch möglich, dass der Anfangsdruck noch geringer ist, beispielsweise kleiner $10^{-7}$ mbar.

Bevorzugt ist ebenfalls eine organische Elektrolumineszenzvorrichtung, wobei eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen $10^{-5}$ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist eine organische Elektrolumineszenzvorrichtung, wobei eine oder mehrere Schichten aus Lösung, wie z. B. durch Spincoating, oder mit einem beliebigen Druckverfahren, wie z. B. Siebdruck, Flexodruck, Offsetdruck, LITI (Light Induced Thermal Imaging, Thermotransferdruck), Ink-Jet Druck (Tintenstrahldruck) oder Nozzle Printing, hergestellt werden. Hierfür sind lösliche Verbindungen nötig, welche beispielsweise durch geeignete Substitution erhalten werden. Diese Verfahren eignen sich insbesondere auch für Oligomere, Dendrimere und Polymere.

Diese Verfahren sind dem Fachmann generell bekannt und können von ihm ohne erfinderisches Zutun auf organische Elektrolumineszenzvorrichtungen enthaltend die erfindungsgemäßen Verbindungen angewandt werden.

Ein weiterer Gegenstand der vorliegenden Erfindung ist daher ein Verfahren zur Herstellung einer erfindungsgemäßen organischen Elektrolumineszenzvorrichtung, wobei mindestens eine Schicht mit einem Sublimationsverfahren aufgebracht wird und/oder dass mindestens eine Schicht mit einem OVPD (Organic Vapour Phase Deposition) Verfahren oder mit Hilfe einer Trägergassublimation aufgebracht wird und/oder dass mindestens eine Schicht aus Lösung, durch Spincoating oder mit einem Druckverfahren aufgebracht wird.

Die erfindungsgemäßen organischen Elektrolumineszenzvorrichtungen zeichnen sich durch einen oder mehrere der folgenden überraschenden Vorteile gegenüber dem Stand der Technik aus:

1. Die erfindungsgemäßen organischen Elektrolumineszenzvorrichtungen weisen eine sehr gute und gegenüber Vorrichtungen gemäß dem Stand der Technik, die ebenfalls TADF zeigen, eine verbesserte Effizienz auf.

2. Die erfindungsgemäßen organischen Elektrolumineszenzvorrichtungen weisen eine sehr geringe Spannung auf.

3. Die erfindungsgemäßen organischen Elektrolumineszenzvorrichtungen weisen eine gegenüber Vorrichtungen gemäß dem Stand der Technik, die ebenfalls TADF zeigen, verbesserte Lebensdauer auf.

4. Im Vergleich zu organischen Elektrolumineszenzvorrichtungen gemäß dem Stand der Technik, die Iridium- oder Platinkomplexe als emittierende Verbindungen enthalten, weisen die erfindungsgemäßen Elektrolumineszenzvorrichtungen eine verbesserte Lebensdauer bei erhöhter Temperatur auf.

Diese oben genannten Vorteile gehen nicht mit einer Verschlechterung der weiteren elektronischen Eigenschaften einher.

Die Erfindung wird durch die nachfolgenden Beispiele näher erläutert, ohne sie dadurch einschränken zu wollen. Der Fachmann kann aus den Schilderungen die Erfindung im gesamten offenbarten Bereich ausführen und ohne erfinderisches Zutun weitere erfindungsgemäße organische Elektrolumineszenzvorrichtungen herstellen.

## Beispiele:

### Bestimmung von HOMO, LUMO, Singulett- und Triplettniveau

Die HOMO- und LUMO-Energieniveaus sowie die Energie des niedrigsten Triplettzustands $T_1$ bzw. des niedrigsten angeregten Singulettzustands $S_1$ der Materialien werden über quantenchemische Rechnungen bestimmt. Hierzu wird das Programmpaket "Gaussian09W" (Gaussian Inc.) verwendet. Zur Berechnung organischer Substanzen ohne Metalle (in Tabelle 4 mit Methode "org." bezeichnet) wird zuerst eine Geometrieoptimierung mit der Methode "Ground State/Semi-empirical/Default Spin/AM1/Charge 0/Spin Singlet" durchgeführt. Im Anschluss erfolgt auf Grundlage der optimierten Geometrie eine Energierechnung. Hierbei wird die Methode "TD-S FC/DFT/Default Spin/B3PW91" mit dem Basissatz "6-31 G(d)" verwendet (Charge 0, Spin Singlet). Für metallhaltige Verbindungen (in Tabelle 4 mit Methode "M-org." bezeichnet) wird die Geometrie über die Methode "Ground State/ Hartree-Fock/Default Spin/LanL2MB/Charge 0/Spin Singlet" optimiert. Die Energierechnung erfolgt analog zu den organischen Substanzen, wie oben beschrieben, mit dem Unterschied, dass für das Metallatom der Basissatz "LanL2DZ" und für die Liganden der Basissatz "6-31 G(d)" verwendet wird. Aus der Energierechnung erhält man das HOMO-Energieniveau HEh bzw. LUMO-Energieniveau LEh in Hartree-Einheiten. Daraus werden die anhand von Cyclovoltammetriemessungen kalibrierten HOMO- und LUMO-Energieniveaus in Elektronenvolt wie folgt bestimmt:

$$\mathrm{HOMO(eV)} = ((\mathrm{HEh}*27.212)-0.9899)/1.1206$$

$$\mathrm{LUMO(eV)} = ((\mathrm{LEh}*27.212)-2.0041)/1.385$$

Diese Werte sind im Sinne dieser Anmeldung als HOMO- bzw. LUMO-Energieniveaus der Materialien anzusehen.

Der niedrigste Triplettzustand $T_1$ ist definiert als die Energie des Triplettzustands mit der niedrigsten Energie, der sich aus der beschriebenen quantenchemischen Rechnung ergibt.

Der niedrigste angeregte Singulettzustand $S_1$ ist definiert als die Energie des angeregten Singulettzustands mit der niedrigsten Energie, der sich aus der beschriebenen quantenchemischen Rechnung ergibt.

In Tabelle 4 sind die HOMO- und LUMO-Energieniveaus sowie $S_1$ und $T_1$ der verschiedenen Materialien angegeben.

## Bestimmung der Photolumineszenz-Quanteneffizienz (PLQE)

Von den in den verschiedenen OLEDs verwendeten Emissionsschichten wird ein 50 nm dicker Film auf ein geeignetes transparentes Substrat, vorzugsweise Quarz, aufgebracht, d. h. die Schicht enthält dieselben Materialien in derselben Konzentration wie in der OLED. Hierbei werden die gleichen Herstellungsbedingungen wie bei der Herstellung der Emissionsschicht für die OLEDs verwendet. Von diesem Film wird ein Absorptionsspektrum im Wellenlängenbereich von 350-500 nm gemessen. Hierzu wird das Reflexionsspektrum $P(\lambda)$ sowie das Transmissionsspektrum $T(\lambda)$ der Probe unter einem Einfallswinkel von 6° (also nahezu senkrechter Einfall) bestimmt. Als Absorptionsspektrum im Sinne dieser Anmeldung wird $A(\lambda)=1-P(\lambda)-T(\lambda)$ definiert.

Gilt $A(\lambda)\leq 0.3$ im Bereich 350-500nm, so wird die zum Maximum des Absorptionsspektrums gehörige Wellenlänge im Bereich 350-500 nm als $\lambda_{exc}$ definiert. Gilt für irgendeine Wellenlänge $A(\lambda) > 0.3$, so wird als $\lambda_{exc}$ die größte Wellenlänge definiert, bei der $A(\lambda)$ von einem Wert kleiner 0.3 zu einem Wert größer 0.3 oder von einem Wert größer 0.3 zu einem Wert kleiner 0.3 wechselt.

Zur Bestimmung der PLQE wird ein Messplatz Hamamatsu C9920-02 verwendet. Das Prinzip beruht auf der Anregung der Probe mit Licht definierter Wellenlänge und der Messung der absorbierten und emittierten Strahlung. Die Probe befindet sich während der Messung in einer Ulbrichtkugel ("integrating sphere"). Das Spektrum des Anregungslichts ist in etwa gaußförmig mit einer Halbwertsbreite < 10 nm und Peakwellenlänge $A_{exc}$ wie oben definiert.

Die PLQE wird nach dem für den genannten Messplatz üblichen Auswerteverfahren bestimmt. Es ist strengstens darauf zu achten, dass die Probe zu keinem Zeitpunkt mit Sauerstoff in Berührung kommt, da die PLQE von Materialien mit kleinem energetischen Abstand zwischen $S_1$ und $T_1$ durch Sauerstoff sehr stark reduziert wird (H. Uoyama et al., Nature 2012, Vol. 492, 234).

In Tabelle 2 ist die PLQE für die Emissionsschichten der OLEDs wie oben definiert zusammen mit der verwendeten Anregungswellenlänge angegeben.

## Bestimmung der Abklingzeit

Zur Bestimmung der Abklingzeit wird eine Probe verwendet, die wie oben unter "Bestimmung der PL-Quanteneffizienz (PLQE)" beschrieben hergestellt wird. Die Probe wird bei einer Temperatur von 295K durch einen Laserpuls angeregt (Wellenlänge 266 nm, Pulsdauer 1.5 ns, Pulsenergie 200 $\mu$J, Strahldurchmesser 4 mm). Die Probe befindet sich hierbei im Vakuum ($<10^{-5}$ mbar). Nach der Anregung (definiert als t = 0) wird der zeitliche Verlauf der Intensität der emittierten Photolumineszenz gemessen. Die Photolumineszenz zeigt am Anfang einen steilen Abfall, der auf die prompte Fluoreszenz der TADF-Verbindung zurückzuführen ist. Im weiteren zeitlichen Verlauf ist ein langsamerer Abfall zu beobachten, die verzögerte Fluoreszenz (siehe z.B. H. Uoyama et al., Nature, vol. 492, no. 7428, pp. 234-238, 2012 sowie K. Masui et al., Organic Electronics, vol. 14, no. 11, pp. 2721-2726, 2013). Die Abklingzeit $t_a$ im Sinne dieser Anmeldung ist die Abklingzeit der verzögerten Fluoreszenz und wird wie folgt bestimmt: Man wählt einen Zeitpunkt $t_d$ zu dem die prompte Fluoreszenz deutlich unter die Intensität der verzögerten Fluoreszenz abgeklungen ist (<1%), so dass die folgende Bestimmung der Abklingzeit davon nicht beeinflusst wird. Diese Wahl kann von einem Fachmann durchgeführt werden. Für die Messdaten ab dem Zeitpunkt $t_d$ wird die Abklingzeit $t_a = t_e - t_d$ bestimmt. Dabei ist $t_e$ derjenige Zeitpunkt nach $t = t_d$, bei dem die Intensität erstmals auf 1/e ihres Wertes bei $t = t_d$ abgefallen ist.

Tabelle 2 zeigt die Werte von $t_a$ und $t_d$, die für die Emissionsschichten der erfindungsgemäßen OLEDs ermittelt werden.

## Beispiele: Herstellung der OLEDs

In den folgenden Beispielen V1 bis E6 (siehe Tabellen 1 und 2) werden die Daten verschiedener OLEDs vorgestellt.

Die Synthese der TP-Verbindung H1 der Formel (13) ist beispielsweise in EP1888708, H2 der Formel (25) und H3 der Formel (26) beispielsweise in WO 2009021126, H4 der Formel (40) in WO 2010132524, H5 der Formel (126) in KR20110041729 und H6 der Formel (90) beispielsweise in WO 2013056776 beschrieben. Die Synthese der TADF-Verbindung D1 wird offenbart in Uoyama, K. Goushi, K. Shizu, H. Nomura und C. Adachi, "Highly efficient organic light-emitting diodes from delayed fluorescence," Nature, vol. 492, no. 7428, pp. 234-238, Dec.2012.

Glasplättchen, die mit strukturiertem ITO (Indium Zinn Oxid) der Dicke 50 nm beschichtet sind werden nass gereinigt (Laborspülmaschine, Reiniger Merck Extran), anschließend 15 min lang bei 250 °C in einer Stickstoffatmosphäre ausgeheizt und vor der Beschichtung 130 s lang mit einem Sauerstoffplasma behandelt. Diese mit Plasma behandelten Glasplättchen bilden die Substrate, auf welche die OLEDs aufgebracht werden. Die Substrate verbleiben vor der Beschichtung im Vakuum. Die Beschichtung beginnt spätestens 10 min nach der Plasmabehandlung.

Die OLEDs haben prinzipiell folgenden Schichtaufbau: Substrat / Lochtransportschicht (HTL) / Emissionsschicht (EML) / Lochblockierschicht (HBL) / Elektronentransportschicht (ETL) und abschließend eine Kathode. Die Kathode

wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 3 gezeigt.

Alle Materialien werden in einer Vakuumkammer thermisch aufgedampft. Dabei besteht die Emissionsschicht immer aus einem Matrixmaterial (Hostmaterial, Wirtsmaterial) und der emittierenden TADF-Verbindung, also dem Material, das einen kleinen energetischen Abstand zwischen $S_1$ und $T_1$ zeigt. Dieses wird dem Matrixmaterial durch Coverdampfung in einem bestimmten Volumenanteil beigemischt. Eine Angabe wie CBP:D1 (95%:5%) bedeutet hierbei, dass das Material CBP in einem Volumenanteil von 95% und D1 in einem Anteil von 5% in der Schicht vorliegt. Analog kann auch die Elektronentransportschicht aus einer Mischung von zwei Materialien bestehen.

Die OLEDs werden standardmäßig charakterisiert. Hierfür werden die Elektrolumineszenzspektren, die Stromeffizienz (gemessen in cd/A), die Leistungseffizienz (gemessen in lm/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/$m^2$ bestimmt und daraus die CIE 1931 x und y Farbkoordinaten berechnet. Die Angabe U1000 in Tabelle 2 bezeichnet die Spannung, die für eine Leuchtdichte von 1000 cd/$m^2$ benötigt wird. SE1000 und LE1000 bezeichnen die Strom- bzw. Leistungseffizienz, die bei 1000 cd/$m^2$ erreicht werden. EQE1000 schließlich bezeichnet die externe Quanteneffizienz bei einer Betriebsleuchtdichte von 1000 cd/$m^2$.

Als Lebensdauer LD wird die Zeit definiert, nach der die Leuchtdichte bei Betrieb mit konstantem Strom von der Startleuchtdichte auf einen gewissen Anteil L1 absinkt. Eine Angabe von j0 = 10mA/$cm^2$, L1 = 80% in Tabelle 2 bedeutet, dass die Leuchtdichte bei Betrieb mit 10 mA/$cm^2$ nach der Zeit LD auf 80% ihres Anfangswertes absinkt.

Als emittierender Dotand in der Emissionsschicht wird die Verbindung D1 eingesetzt, die einen energetischen Abstand zwischen $S_1$ und $T_1$ von 0.09 eV aufweist.

Die Daten der verschiedenen OLEDs sind in Tabelle 2 zusammengefasst. Das Beispiel V1 ist ein Vergleichsbeispiel gemäß dem Stand der Technik, die Beispiele E1-E6 zeigen Daten von erfindungsgemäßen OLEDs.

Wie sich der Tabelle entnehmen lässt, erhält man mit erfindungsgemäßen Emissionsschichten deutliche Verbesserungen bezüglich Spannung und/oder Effizienz und/oder Lebensdauer gegenüber dem Stand der Technik. Insbesondere lässt sich die Lebensdauer mit Verbindung H3 als Matrixmaterial gegenüber CBP mehr als verdoppeln, mit Verbindung H6 erhält man eine um 0.5 V bessere Spannung und 40% verbesserte Effizienz.

**Tabelle 1:** Aufbau der OLEDs

| Bsp | HTL Dicke | EML Dicke | HBL Dicke | ETL Dicke |
|---|---|---|---|---|
| V1 | SpMA1 90nm | CBP:D1 (95%:5%) 15nm | IC1 10nm | ST2:LiQ (50%:50%) 40nm |
| E1 | SpMA1 90nm | H1:D1 (95%:5%) 15nm | IC1 10nm | ST2:LiQ (50%:50%) 40nm |
| E2 | SpMA1 90nm | H2:D1 (95%:5%) 15nm | IC1 10nm | ST2:LiQ (50%:50%) 40nm |
| E3 | SpMA1 90nm | H3:D1 (95%:5%) 15nm | IC1 10nm | ST2:LiQ (50%:50%) 40nm |
| E4 | SpMA1 90nm | H4:D1 (95%:5%) 15nm | IC1 10nm | ST2:LiQ (50%:50%) 40nm |
| E5 | SpMA1 90nm | H5:D1 (95%:5%) 15nm | IC1 10nm | ST2:LiQ (50%:50%) 40nm |
| E6 | SpMA1 90nm | H6:D1 (95%:5%) 15nm | IC1 10nm | ST2:LiQ 50%:50% 40nm |

**Tabelle 2:** Daten der OLEDs

| Bsp | U1000 (V) | SE1000 (cd/A) | LE1000 (lm/W) | EQE 1000 | CIE x/y bei 1000 $cd/m^2$ | j0 $mA/cm^2$ | L1 % | LD (h) | PLQE % | $\lambda_{exc}$ nm | $t_d$ µs | $t_a$ µs |
|---|---|---|---|---|---|---|---|---|---|---|---|---|
| V1 | 4.2 | 43 | 32 | 13.7% | 0.25/0.58 | 10 | 80 | 22 | 100 | 350 | 7 | 4.5 |
| E1 | 4.2 | 47 | 35 | 15.0% | 0.25/0.58 | 10 | 80 | 27 | 93 | 350 | 6 | 4.7 |
| E2 | 3.7 | 44 | 37 | 13.6% | 0.27/0.59 | 10 | 80 | 43 | 83 | 350 | 6 | 4.4 |
| E3 | 4.1 | 38 | 29 | 12.3% | 0.25/0.58 | 10 | 80 | 53 | 86 | 350 | 4 | 4.8 |
| E4 | 3.8 | 49 | 41 | 15.3% | 0.27/0.58 | 10 | 80 | 17 | 90 | 350 | 7 | 5.0 |
| E5 | 4.0 | 41 | 32 | 12.6% | 0.32/0.58 | 10 | 80 | 28 | 96 | 350 | 7 | 5.6 |
| E6 | 3.7 | 60 | 51 | 19.3% | 0.25/0.57 | 10 | 80 | 31 | 95 | 350 | 5 | 4.3 |

**Tabelle 3:** Strukturformeln der Materialien für die OLEDs. Die Verbindungen H1 bis H6 entsprechen den oben aufgeführten Formeln (13), (25), 26, (40), (126) und (90)

| | |
|---|---|
| 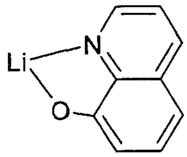 | 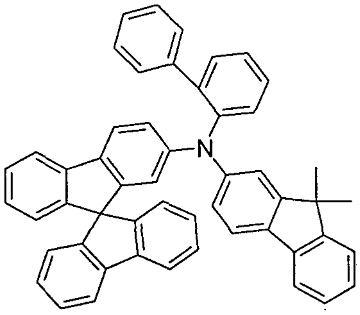 |
| LiQ | SpMA1 |
| 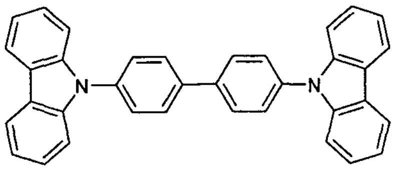 | 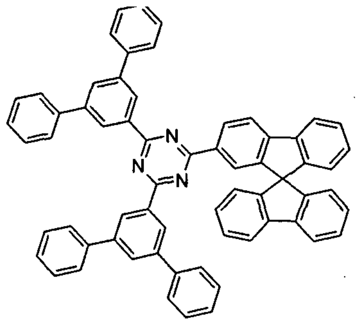 |
| CBP | ST2 |
| 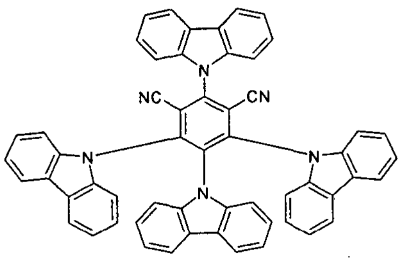 | 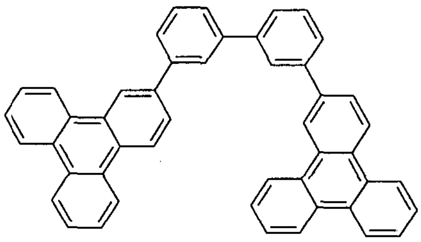 |
| D1 | H1 |
| 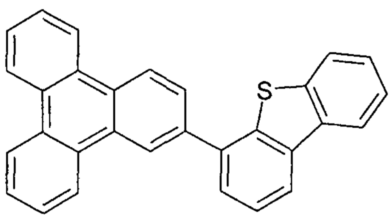 | 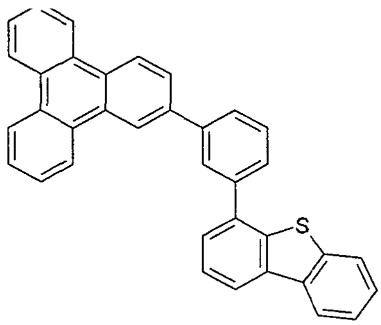 |
| H2 | H3 |

(fortgesetzt)

| | |
|---|---|
| 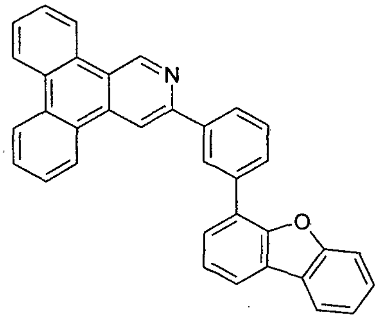 | 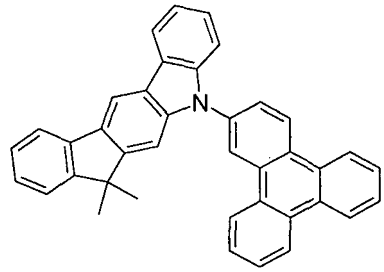 |
| H4 | H5 |
| 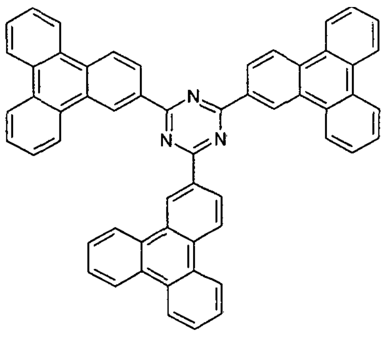 | 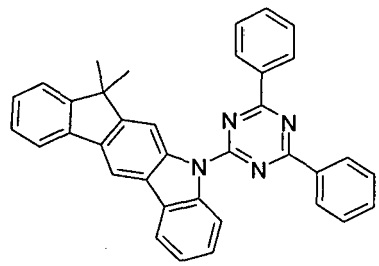 |
| H6 | IC1 |

**Tabelle 4:** HOMO, LUMO, $T_1$, $S_1$ der relevanten Materialien

| Material | Methode | HOMO (eV) | LUMO (eV) | $S_1$ (eV) | $T_1$ (eV) |
|---|---|---|---|---|---|
| D1 | orq. | -6.11 | -3.40 | 2.50 | 2.41 |
| CBP | orq. | -5.67 | -2.38 | 3.59 | 3.11 |
| IC1 | org. | -5.79 | -2.83 | 3.09 | 2.69 |
| H1 | org. | -6.06 | -2.39 | 3.43 | 2.70 |
| H2 | org. | -5.93 | -2.46 | 3.49 | 2.66 |
| H3 | org. | -6.01 | -2.39 | 3.46 | 2.70 |
| H4 | org. | -6.00 | -2.11 | 3.41 | 2.69 |
| H5 | orq. | -5.53 | -2.39 | 3.27 | 2.68 |
| H6 | org. | -6.29 | -2.90 | 3.22 | 2.63 |

## Patentansprüche

**1.** Organische Elektrolumineszenzvorrichtung, enthaltend Kathode, Anode und emittierende Schicht, die die folgenden Verbindungen enthält:

(A) mindestens eine lumineszente organische Verbindung, die einen Abstand zwischen dem niedrigsten Triplettzustand $T_1$ und dem ersten angeregten Singulettzustand $S_1$ von $\leq 0.15$ eV aufweist (TADF-Verbindung); und
(B) mindestens eine organische Verbindung mit mindestens einer Triphenylengruppe und/oder einer Azatriphenylengruppe, die bis zu sechs Aza-Stickstoffatome aufweist (TP-Verbindung),
wobei die TP-Verbindung die Formel (1) oder (2) aufweist,

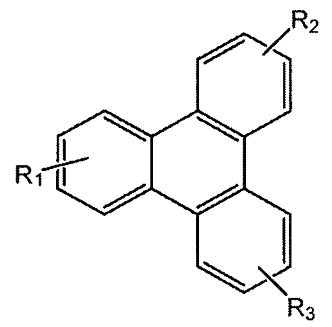

(1)

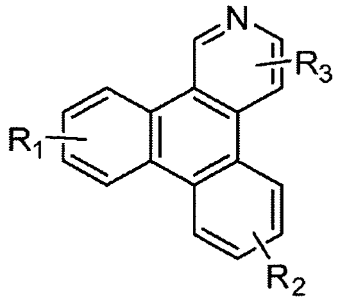

(2)

oder wobei die TP-Verbindung der Formel (2) entspricht und bis zu fünf weitere Aza-Stickstoffatome aufweist, die C-H Gruppen der in Formel (2) gezeigten Monoazatriphenylengruppe ersetzen,
wobei die Reste $R_1$, $R_2$ und $R_3$ unabhängig voneinander ausgewählt sind,
wobei jeweils keiner, einer oder mehrere Reste $R_1$, $R_2$ oder $R_3$ vorhanden sein können, wobei mehrere Reste von $R_1$, von $R_2$ oder von $R_3$ jeweils unabhängig voneinander ausgewählt werden,
wobei die Reste $R_1$, $R_2$ oder $R_3$ ausgewählt sind aus

(i) einer aromatischen Gruppe, die mit der Triphenylengruppe oder Azatriphenylengruppe ein konjugiertes System bildet, wobei die aromatische Gruppe 5 bis 80 aromatische Ringatome aufweist, die mit einem oder mehreren Resten $R_4$ substituiert sein können, wobei $R_4$ unabhängig voneinander ausgewählt ist aus H, D, F, Cl, F, Br, unverzweigtem Alkyl- mit 1 bis 20 C-Atomen, verzweigtem oder cyclischem Alkyl- mit 3 bis 20 C-Atomen, wobei zwei oder mehr Reste $R_4$ miteinander verknüpft sein können und einen Ring bilden können, und
(ii) einem Alkylrest $R_5$, ausgewählt aus unverzweigtem Alkyl- mit 1 bis 20 C-Atomen, verzweigtem oder cyclischem Alkyl- mit 3 bis 20 C-Atomen, wobei zwei Reste $R_5$ miteinander verknüpft sein können und einen Ring bilden können,
mit der Maßgabe, dass mindestens ein Rest $R_1$, $R_2$ oder $R_3$ vorhanden ist, der eine aromatische Gruppe (i) ist;

dabei wird das HOMO, das LUMO, der $T_1$-Zustand und der $S_1$-Zustand über quantenchemische Rechnungen mit dem Programmpaket "Gaussian09W" (Gaussian Inc.) wie folgt bestimmt:

- zur Berechnung organischer Substanzen ohne Metalle wird eine Geometrieoptimierung mit der Methode "Ground State/Semi-empirical /Default Spin/AM1/Charge 0/Spin Singlet" durchgeführt;
- dann erfolgt auf Grundlage der optimierten Geometrie eine Energierechnung mit der Methode "TD-SFC/DFT/Default Spin/B3PW91" mit dem Basissatz "6-31G(d)" (Charge 0, Spin Singlet);
- zur Berechnung metallhaltiger Verbindungen wird die Geometrie über die Methode "Ground State/ Hartree-Fock/Default Spin/LanL2MB/ Charge 0/Spin Singlet" optimiert und die Energierechnung analog zu den organischen Substanzen durchgeführt, mit dem Unterschied, dass für das Metallatom der Basissatz "LanL2DZ" und für die Liganden der Basissatz "6-31G(d)" verwendet wird;
- aus den aus der Energierechnung erhaltenen HOMO-Energienviveau HEh und LUMO-Energieniveau LEh in Hartree-Einheiten wird das anhand von Cyclovoltammetriemessungen kalibrierte HOMO- bzw. LUMO-Energieniveau in Elektronenvolt wie folgt bestimmt:

$$HOMO(eV) = ((HEh*27.212)-0.9899)/1.1206$$

$$LUMO(eV) = ((LEh*27.212)-2.0041)/1.385;$$

- $T_1$ ist die Energie des Triplettzustands mit der niedrigsten Energie, der sich aus der beschriebenen quantenchemischen Rechnung ergibt;

- $S_1$ ist die Energie des angeregten Singulettzustands mit der niedrigsten Energie, der sich aus der beschriebenen quantenchemischen Rechnung ergibt.

2. Organische Elektrolumineszenzvorrichtung nach Anspruch 1, wobei der Abstand zwischen $S_1$ und $T_1$ der TADF-Verbindung $\leq 0.10$ eV, bevorzugt $\leq 0.08$ eV und besonders bevorzugt $\leq 0.05$ eV ist.

3. Organische Elektrolumineszenzvorrichtung nach Anspruch 1 oder 2, wobei die TADF-Verbindung eine aromatische Verbindung ist, die sowohl Donor- wie auch Akzeptorsubstituenten aufweist.

4. Organische Elektrolumineszenzvorrichtung nach einem oder mehreren der Ansprüche 1 bis 3, wobei für das LUMO der TADF-Verbindung LUMO(TADF) und das HOMO der TP-Verbindung HOMO(Matrix) gilt:

$$\text{LUMO(TADF)} - \text{HOMO(Matrix)} > S_1\text{(TADF)} - 0.4\text{ eV},$$

wobei $S_1$(TADF) der erste angeregte Singulettzustand $S_1$ der TADF-Verbindung ist.

5. Organische Elektrolumineszenzvorrichtung nach einem oder mehreren der Ansprüche 1 bis 4, wobei die niedrigste Triplettenergie der TP-Verbindung maximal 0.1 eV niedriger ist als die niedrigste Triplettenergie der TADF-Verbindung.

6. Organische Elektrolumineszenzvorrichtung nach einem oder mehreren der Ansprüche 1 bis 5, wobei $R_1$, $R_2$ oder $R_3$ über eine konjugierte C-C Einfachbindung mit der Triphenylengruppe oder Azatriphenylengruppe verbunden ist; und/oder
wobei $R_1$, $R_2$ und/oder $R_3$ eine an die Triphenylengruppe und/oder Azatriphenylengruppe anellierte aromatische Gruppe ist oder aufweist.

7. Organische Elektrolumineszenzvorrichtung nach einem oder mehreren der Ansprüche 1 bis 6, wobei die TP-Verbindung mindestens eine der folgenden Struktureinheiten aufweist:

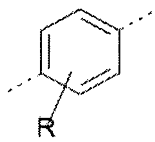 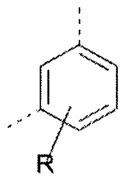 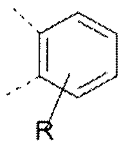

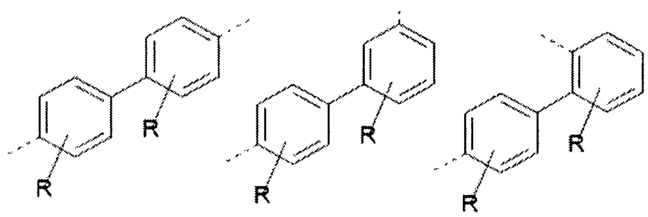

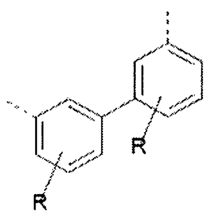 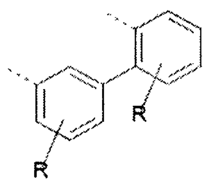 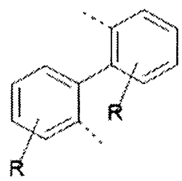

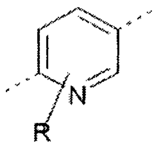 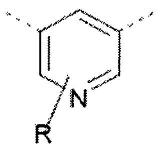 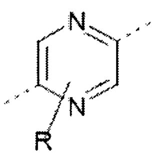 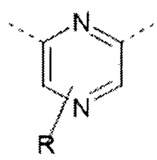 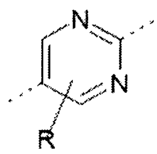

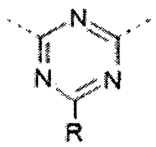 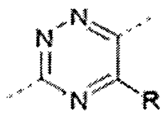 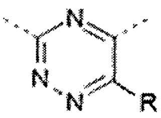

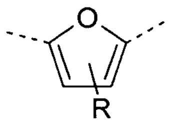 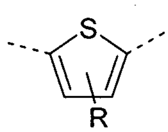 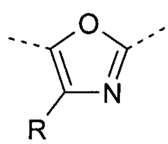 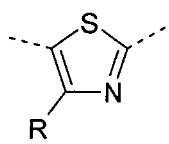

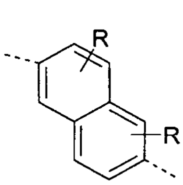 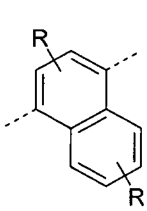 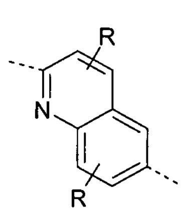 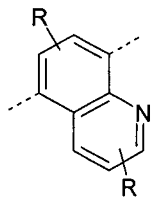

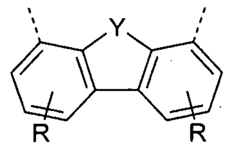 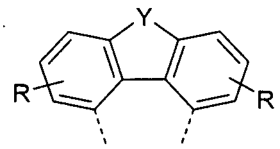

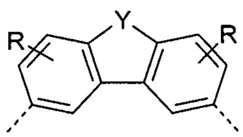 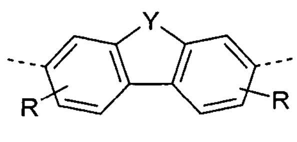

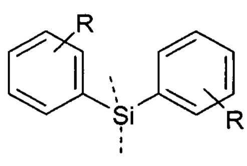

wobei R ausgewählt ist wie in Anspruch 1 für $R_4$ angegeben, oder wobei R eine aromatische Gruppe ist, die mit einem oder mehreren Resten $R_4$ substituiert sein kann,

wobei Y ausgewählt ist aus $C(R_6)_2$, $NR_6$, S, O und Se, wobei $R_6$ ausgewählt ist aus H, unverzweigtem Alkyl- mit 1 bis 20 C-Atomen, verzweigtem oder cyclischem Alkyl- mit 3 bis 20 C-Atomen, und einer aromatischen Gruppe, die eine Aryl oder Heteroarylgruppe sein kann, insbesondere Phenyl, wobei zwei Reste $R_6$ miteinander verknüpft sein können und einen Ring bilden können, und

wobei die gestrichelten Linien für Einfachbindungen stehen.

**8.** Organische Elektrolumineszenzvorrichtung nach einem oder mehreren der Ansprüche 1 bis 7, wobei mindestens ein Rest $R_1$, $R_2$ oder $R_3$ eine Struktureinheit aufweist, die ausgewählt ist aus Phenyl, Naphthyl, Biphenyl, Benzofuran,

Benzothiophen, Carbazol, Azacarbazol, Dibenzothiophen, Dibenzofuran, Triphenylen und Azinen, wie Triazin, Pyrimidin oder Pyridin.

**9.** Organische Elektrolumineszenzvorrichtung nach einem oder mehreren der Ansprüche 1 bis 8, wobei mindestens ein Rest $R_1$, $R_2$ oder $R_3$ eine Gruppe aufweist, die elektronenschiebend ist und einen +M-Effekt ausübt.

**10.** Organische Elektrolumineszenzvorrichtung nach Anspruch 9, wobei die elektronenschiebende Gruppe eine elektronenreiche Heteroarylgruppe ist, die ein Heteroatom aufweist, das ausgewählt ist aus N, O, S und Se.

**11.** Organische Elektrolumineszenzvorrichtung nach einem oder mehreren der Ansprüche 1 bis 10, wobei mindestens ein Rest $R_1$, $R_2$ oder $R_3$ eine Gruppe aufweist, die elektronenziehend ist und einen -M-Effekt ausübt.

**12.** Organische Elektrolumineszenzvorrichtung nach einem oder mehreren der Ansprüche 1 bis 10, wobei die TP-Verbindung keinen Substituenten aufweist, der elektronenziehend ist und einen -M-Effekt ausübt.

**13.** Verfahren zur Herstellung einer organischen Elektrolumineszenzvorrichtung nach einem oder mehreren der Ansprüche 1 bis 12, wobei mindestens eine Schicht mit einem Sublimationsverfahren aufgebracht wird und/oder mindestens eine Schicht mit einem OVPD (Organic Vapour Phase Deposition) Verfahren oder mit Hilfe einer Trägergassublimation aufgebracht wird und/oder mindestens eine Schicht aus Lösung, durch Spincoating oder mit einem Druckverfahren aufgebracht wird.

## Claims

**1.** Organic electroluminescent device comprising cathode, anode and emitting layer, comprising the following compounds:

(A) at least one luminescent organic compound having a gap between the lowest triplet state $T_1$ and the first excited singlet state $S_1$ of $\leq 0.15$ eV (TADF compound); and
(B) at least one organic compound having at least one triphenylene group and/or one azatriphenylene group having up to six aza nitrogen atoms (TP compound),
wherein the TP compound has the formula (1) or (2)

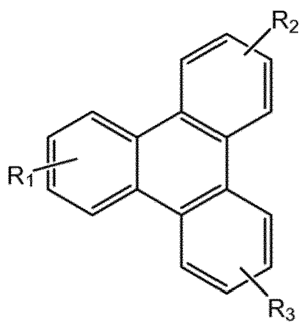

(1)

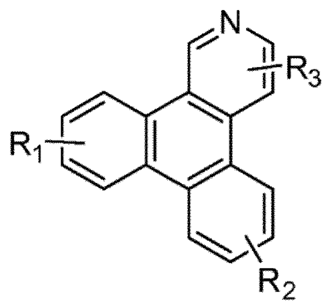

(2)

or wherein the TP compound conforms to the formula (2) and has up to five further aza nitrogen atoms which replace C-H groups in the monoazatriphenylene group shown in formula (2),
where the $R_1$, $R_2$ and $R_3$ radicals are selected independently of one another,
where no, one or more $R_1$, $R_2$ or $R_3$ radicals may be present in each case, where two or more radicals of $R_1$, of $R_2$ or of $R_3$ are selected independently of one another,
where the $R_1$, $R_2$ or $R_3$ radicals are selected from

(i) an aromatic group which forms a conjugated system with the triphenylene group or azatriphenylene group, where the aromatic group has 5 to 80 aromatic ring atoms which may be substituted by one or more $R_4$ radicals, where $R_4$ is independently selected from H, D, F, Cl, F, Br, unbranched alkyl having 1 to 20 carbon atoms, branched or cyclic alkyl having 3 to 20 carbon atoms, where two or more $R_4$ radicals may

be joined to one another and may form a ring, and
(ii) an alkyl radical $R_5$ selected from unbranched alkyl having 1 to 20 carbon atoms, branched or cyclic alkyl having 3 to 20 carbon atoms, where two $R_5$ radicals may be joined to one another and may form a ring, with the proviso that at least one $R_1$, $R_2$ or $R_3$ radical which is an aromatic group (i) is present;

where the HOMO, the LUMO, the $T_1$ state and the $S_1$ state are thus determined via quantum-chemical calculations with the "Gaussian09W" (Gaussian Inc.) software package as follows:

- for calculation of organic substances without metals, an optimization of geometry is first conducted by the "Ground State/Semi-empirical/Default Spin/AM1/Charge 0/Spin Singlet" method;
- then an energy calculation is effected on the basis of the optimized geometry using the "TD-SFC/DFT/Default Spin/B3PW91" method with the "6-31G(d)" basis set (charge 0, spin singlet);
- for calculation of metal-containing compounds, the geometry is optimized via the "Ground State/Hartree-Fock/Default Spin/LanL2MB/Charge 0/Spin Singlet" method and the energy calculation is effected analogously to the organic substances except that the "LanL2DZ" basis set is used for the metal atom and the "6-31G (d)" basis set for the ligands;
- the HOMO energy level HEh and LUMO energy level LEh obtained from the energy calculation in Hartree units are used to determine the HOMO and LUMO energy levels in electron volts, calibrated by cyclic voltammetry measurements, as follows:

$$HOMO(eV) = ((HEh*27.212)-0.9899)/1.1206$$

$$LUMO(eV) = ((LEh*27.212)-2.0041)/1.385;$$

- $T_1$ is the energy of the triplet state having the lowest energy, which is apparent from the quantum-chemical calculation described;
- $S_1$ is the energy of the excited singlet state having the lowest energy, which is apparent from the quantum-chemical calculation described.

**2.** Organic electroluminescent device according to Claim 1, wherein the separation between $S_1$ and $T_1$ of the TADF compound is ≤ 0.10 eV, preferably ≤ 0.08 eV and more preferably ≤ 0.05 eV.

**3.** Organic electroluminescent device according to Claim 1 or 2, wherein the TADF compound is an aromatic compound having both donor and acceptor substituents.

**4.** Organic electroluminescent device according to one or more of Claims 1 to 3, wherein the following condition applies to the LUMO of the TADF compound LUMO(TADF) and the HOMO of the TP compound HOMO(matrix):

$$LUMO(TADF) - HOMO(matrix) > S_1(TADF) - 0.4\ eV,$$

where $S_1$(TADF) is the first excited singlet state $S_1$ of the TADF compound.

**5.** Organic electroluminescent device according to one or more of Claims 1 to 4, wherein the lowest triplet energy of the TP compound is not more than 0.1 eV lower than the lowest triplet energy of the TADF compound.

**6.** Organic electroluminescent device according to one or more of Claims 1 to 5, wherein $R_1$, $R_2$ or $R_3$ is bonded to the triphenylene group or azatriphenylene group via a conjugated C-C single bond; and/or where $R_1$, $R_2$ and/or $R_3$ is or has an aromatic group fused to the triphenylene group and/or azatriphenylene group.

**7.** Organic electroluminescent device according to one or more of Claims 1 to 6, wherein the TP compound has at least one of the following structural units:

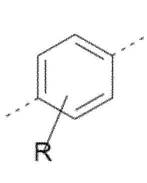
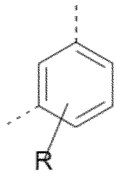
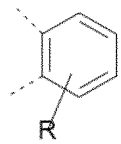

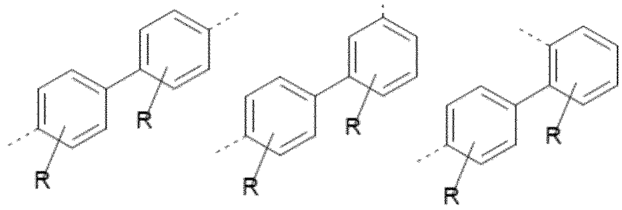

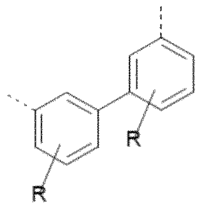
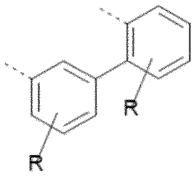
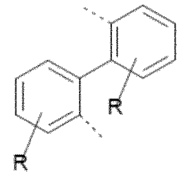

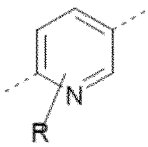
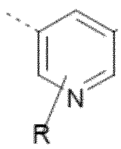
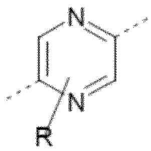
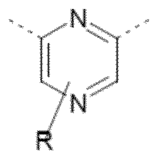
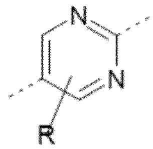

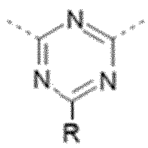
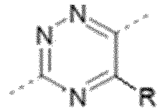
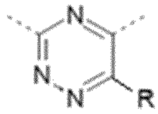

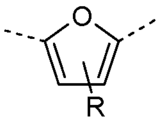
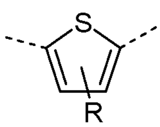
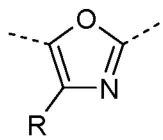
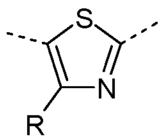

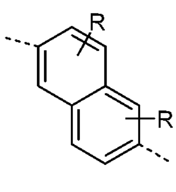
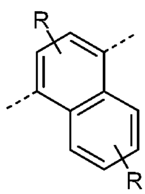
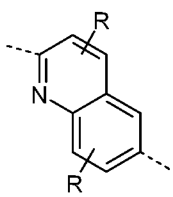
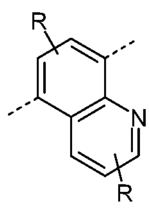

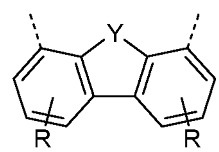
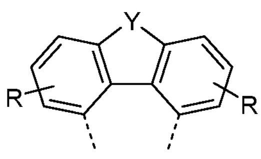

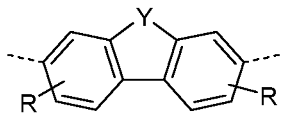

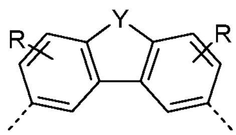

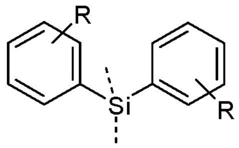

where R is selected as specified for $R_4$ in Claim 1, or where R is an aromatic group which may be substituted by one or more $R_4$ radicals,
where Y is selected from $C(R_6)_2$, $NR_6$, S, O and Se, where $R_6$ is selected from H, unbranched alkyl having 1 to 20 carbon atoms, branched or cyclic alkyl having 3 to 20 carbon atoms, and an aromatic group which may be an aryl or heteroaryl group, especially phenyl, where two $R_6$ radicals may be joined to one another and may form a ring, and where the dotted lines represent single bonds.

**8.** Organic electroluminescent device according to one or more of Claims 1 to 7, wherein at least one $R_1$, $R_2$ or $R_3$ radical has a structural unit selected from phenyl, naphthyl, biphenyl, benzofuran, benzothiophene, carbazole, azacarbazole, dibenzothiophene, dibenzofuran, triphenylene and azines such as triazine, pyrimidine or pyridine.

**9.** Organic electroluminescent device according to one or more of Claims 1 to 8, wherein at least one $R_1$, $R_2$ or $R_3$ radical has an electron-donating group that exerts a +M effect.

**10.** Organic electroluminescent device according to Claim 9, wherein the electron-donating group is an electron-rich heteroaryl group having a heteroatom selected from N, O, S and Se.

**11.** Organic electroluminescent device according to one or more of Claims 1 to 10, wherein at least one $R_1$, $R_2$ or $R_3$ radical has an electron-withdrawing group that exerts a -M effect.

**12.** Organic electroluminescent device according to one or more of Claims 1 to 10, wherein the TP compound does not have any electron-withdrawing substituent that exerts a -M effect.

**13.** Process for producing an organic electroluminescent device according to one or more of Claims 1 to 12, wherein at least one layer is applied by a sublimation method and/or at least one layer is applied by an OVPD (organic vapour phase deposition) method or with the aid of a carrier gas sublimation and/or at least one layer is applied from solution, by spin-coating or by a printing method.

**Revendications**

**1.** Dispositif organique d'électroluminescence, contenant cathode, anode et couche émettrice, qui contient les composés suivants :

(A) au moins un composé organique luminescent, qui présente une distance entre l'état triplet le plus bas $T_1$ et le premier état singulet excité $S_1$ de $\leq 0,15$ eV (composé TADF) ; et
(B) au moins un composé organique comportant au moins un groupe triphénylène et/ou un groupe azatriphénylène, qui présente jusqu'à six atomes d'azote aza (composé TP),
le composé TP présentant la formule (1) ou (2),

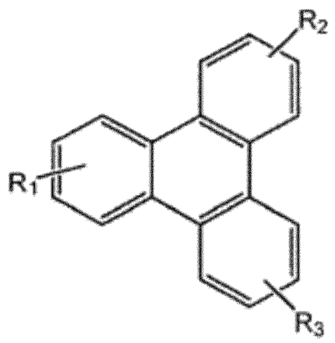

(1)

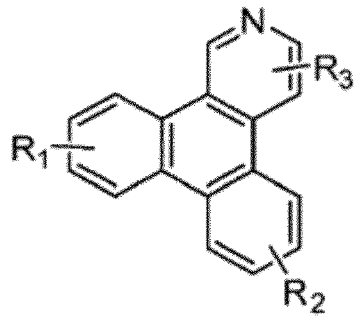

(2)

ou le composé TP correspondant à la formule (2) et présentant jusqu'à cinq atomes d'azote aza supplémentaires qui remplacent des groupes C-H du groupe monoazatriphénylène indiqué dans la formule (2),
les radicaux $R_1$, $R_2$ et $R_3$ étant choisis indépendamment les uns des autres,
à chaque fois aucun, un ou plusieurs des radicaux $R_1$, $R_2$ ou $R_3$ pouvant être présents, plusieurs radicaux de $R_1$, de $R_2$ ou de $R_3$ étant choisis à chaque fois indépendamment les uns des autres,
les radicaux $R_1$, $R_2$ ou $R_3$ étant choisis parmi

(i) un groupe aromatique, qui forme un système conjugué avec le groupe triphénylène ou le groupe azatriphénylène, le groupe aromatique présentant 5 à 80 atomes de cycle aromatique, qui peuvent être substitués par un ou plusieurs radicaux $R_4$, $R_4$ étant choisi indépendamment l'un de l'autre parmi H, D, F, Cl, F, Br, alkyle non ramifié comportant 1 à 20 atomes de C, alkyle ramifié ou cyclique comportant 3 à 20 atomes de C, deux radicaux $R_4$ ou plus pouvant être reliés l'un à l'autre et pouvant former un cycle, et
(ii) un radical alkyle $R_5$, choisi parmi alkyle non ramifié comportant 1 à 20 atomes de C, alkyle ramifié ou cyclique comportant 3 à 20 atomes de C, deux radicaux $R_5$ pouvant être reliés l'un à l'autre et pouvant former un cycle, à la condition qu'au moins un radical $R_1$, $R_2$ ou $R_3$ soit présent, qui est un groupe aromatique (i) ;

à cet effet, l'HOMO, la LUMO, l'état $T_1$ et l'état $S_1$ sont déterminés comme suit au moyen de calculs de chimie quantique avec l'ensemble de programmes « Gaussian09W » (Gaussian Inc.) :

- pour le calcul de substances organiques sans métaux, une optimisation de géométrie est mise en œuvre avec la méthode « Ground State/Semi-empirical/Default Spin/AM1/Charge 0/Spin Singlet » ;
- ensuite, sur la base de la géométrie optimisée, un calcul d'énergie est réalisé avec la méthode « TD-SFC/DFT/Default Spin/B3PW91 » avec l'ensemble de base « 6-31G(d) » (Charge 0, Spin Singlet) ;
- pour le calcul de composés contenant un métal, la géométrie est optimisée au moyen de la méthode « Ground State/Hartree-Fock/Default Spin/LanL2MB/Charge 0/Spin Singlet » et le calcul d'énergie est mis en œuvre de manière analogue aux substances organiques, à la différence que pour l'atome de métal, l'ensemble de base « LanL2DZ » est utilisé et pour les ligands, l'ensemble de base « 6-31G(d) » est utilisé ;
- à partir du niveau d'énergie HEh de l'HOMO et du niveau d'énergie LEh de la LUMO obtenus du calcul d'énergie, en unités Hartree, le niveau d'énergie de l'HOMO respectivement de la LUMO, calibré au moyen de mesures de cyclovoltamétrie, en électronvolts est déterminé comme suit :

$$\mathrm{HOMO(eV)} = ((\mathrm{HEh} * 27{,}212) - 0{,}9899)/1{,}1206$$

$$\mathrm{LUMO(eV)} = ((\mathrm{LEh} * 27{,}212) - 2{,}0041)/1{,}385 ;$$

- $T_1$ est l'énergie de l'état triplet comportant l'énergie la plus basse, qui résulte du calcul de chimie quantique décrit ;
- $S_1$ est l'énergie de l'état singulet excité comportant l'énergie la plus basse, qui résulte du calcul de chimie quantique décrit.

2. Dispositif d'électroluminescence organique selon la revendication 1, la distance entre $S_1$ et $T_1$ du composé TADF étant ≤ 0,10 eV, préférablement ≤ 0,08 eV et particulièrement préférablement ≤ 0,05 eV.

3. Dispositif d'électroluminescence organique selon la revendication 1 ou 2, le composé TADF étant un composé aromatique qui présente aussi bien des substituants donneurs que des substituants accepteurs.

4. Dispositif d'électroluminescence organique selon l'une ou plusieurs des revendications 1 à 3, la LUMO du composé TADF LUMO(TADF) et l'HOMO du composé TP HOMO(matrice) satisfaisant à :

$$\mathrm{LUMO(TADF)} - \mathrm{HOMO(matrice)} > S_1\mathrm{(TADF)} - 0{,}4\ \mathrm{eV},$$

$S_1$ (TADF) étant le premier état singulet excité $S_1$ du composé TADF.

5. Dispositif d'électroluminescence organique selon l'une ou plusieurs des revendications 1 à 4, l'énergie triplet la plus basse du composé TP étant au maximum 0,1 eV plus basse que l'énergie triplet la plus basse du composé TADF.

6. Dispositif d'électroluminescence organique selon l'une ou plusieurs des revendications 1 à 5, $R_1$, $R_2$ ou $R_3$ étant relié avec le groupe triphénylène ou le groupe azatriphénylène par l'intermédiaire d'une simple liaison conjuguée C-C ; et/ou $R_1$, $R_2$ et/ou $R_3$ étant ou présentant un groupe aromatique annelé au groupe triphénylène et/ou au groupe azatriphénylène.

7. Dispositif d'électroluminescence organique selon l'une ou plusieurs des revendications 1 à 6, le composé TP présentant au moins l'un des motifs structuraux suivants :

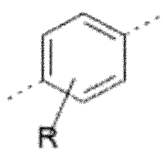
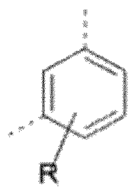
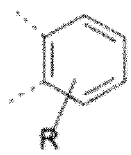

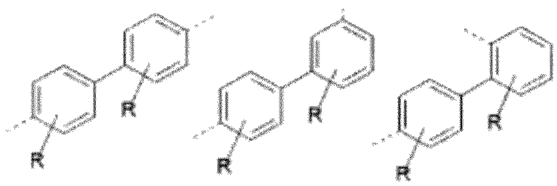

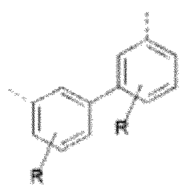
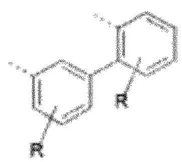
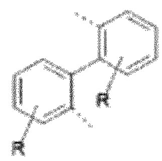

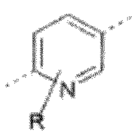
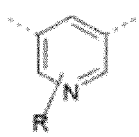
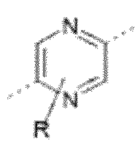
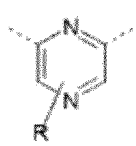
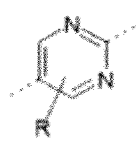

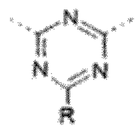 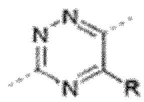 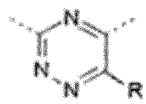

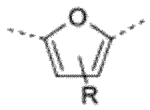 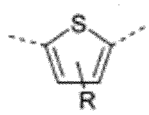 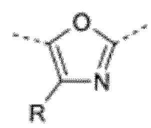 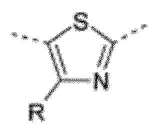

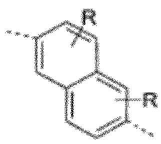 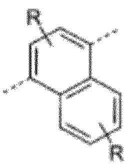 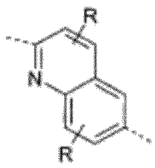 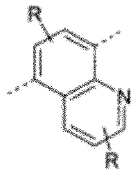

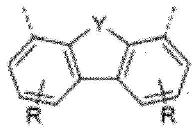 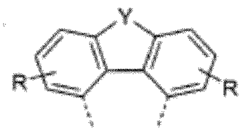

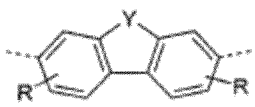 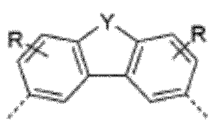

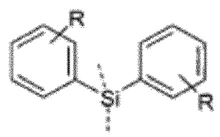

R étant choisi comme indiqué dans la revendication 1 pour $R_4$, ou R étant un groupe aromatique qui peut être substitué par un ou plusieurs radicaux $R_4$,
Y étant choisi parmi $C(R_6)_2$, $NR_6$, S, O et Se, $R_6$ étant choisi parmi H, alkyle non ramifié comportant 1 à 20 atomes de C, alkyle ramifié ou cyclique comportant 3 à 20 atomes de C, et un groupe aromatique qui peut être un groupe aryle ou hétéroaryle, en particulier phényle, deux radicaux $R_6$ pouvant être reliés l'un à l'autre et pouvant former un cycle, et
les lignes en pointillés représentant des simples liaisons.

**8.** Dispositif d'électroluminescence organique selon l'une ou plusieurs des revendications 1 à 7, au moins un radical $R_1$, $R_2$ ou $R_3$ présentant un motif structural qui est choisi parmi phényle, naphtyle, biphényle, benzofuranne, benzothiophène, carbazole, azacarbazole, dibenzothiophène, dibenzofuranne, triphénylène et des azines, comme triazine, pyrimidine ou pyridine.

**9.** Dispositif d'électroluminescence organique selon l'une ou plusieurs des revendications 1 à 8, au moins un radical $R_1$, $R_2$ ou $R_3$ présentant un groupe qui est donneur d'électron et qui exerce un effet +M.

**10.** Dispositif d'électroluminescence organique selon la revendication 9, le groupe donneur d'électron étant un groupe hétéroaryle riche en électrons, qui présente un hétéroatome qui est choisi parmi N, O, S et Se.

11. Dispositif d'électroluminescence organique selon l'une ou plusieurs des revendications 1 à 10, au moins un radical $R_1$, $R_2$ ou $R_3$ présentant un groupe qui est attracteur d'électron et qui exerce un effet -M.

12. Dispositif d'électroluminescence organique selon l'une ou plusieurs des revendications 1 à 10, le composé TP ne présentant aucun substituant qui est attracteur d'électron et qui exerce un effet -M.

13. Procédé pour la préparation d'un dispositif d'électroluminescence organique selon l'une ou plusieurs des revendications 1 à 12, au moins une couche étant appliquée avec un procédé de sublimation et/ou au moins une couche étant appliquée avec un procédé OVPD (Organic Vapour Phase Deposition - dépôt organique en phase vapeur) ou à l'aide d'une sublimation de gaz porteur et/ou au moins une couche étant appliquée à partir d'une solution, par revêtement par centrifugation ou avec un procédé d'impression.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 4539507 A
- US 5151629 A
- EP 0676461 A
- WO 9827136 A
- EP 2213641 A1
- WO 2013154064 A
- WO 2013133359 A
- WO 2013161437 A
- WO 2013081088 A
- WO 2013011954 A
- JP 2013116975 A
- US 20120241732 A
- WO 2009021126 A
- WO 2009021107 A2
- WO 2006130598 A2
- WO 2010132524 A1
- WO 2011137157 A1
- WO 2009037155 A1
- JP 2006143845 A
- KR 20110041729
- WO 2011081423 A
- WO 2011081451 A1
- WO 2013056776 A
- WO 2012039561 A1
- WO 2011073149 A
- EP 1968131 A
- EP 2276085 A
- EP 2213662 A
- EP 1722602 A
- EP 2045848 A
- DE 102007031220
- US 8044390 B
- US 8057712 B
- WO 2009003455 A
- WO 2010094378 A
- WO 2011120709 A
- US 20100096600 A
- EP 1888708 A
- WO 2010132524 A


### In der Beschreibung aufgeführte Nicht-Patentliteratur


- **M. A. BALDO et al.** *Appl. Phys. Lett.,* 1999, vol. 75, 4-6
- **UOYAMA et al.** *Nature,* 2012, vol. 492, 234
- **H. UOYAMA et al.** *Nature,* 2012, vol. 492, 234
- **ENDO et al.** *Appl. Phys. Lett.,* 2011, vol. 98, 083302
- **NAKAGAWA et al.** *Chem. Commun.,* 2012, vol. 48, 9580
- **LEE et al.** *Appl. Phys. Lett.,* 2012, vol. 101, 093306, , 1
- **MEHES et al.** *Angew. Chem. Int. Ed.,* 2012, vol. 51, 11311
- **TANAKA et al.** *Chemistry of Materials,* 2013, vol. 25 (18), 3766
- **LEE et al.** *Journal of Materials Chemistry C,* 2013, vol. 1 (30), 4599
- **ZHANG et al.** *Nature Photonics advance online publication,* 2014, vol. 1
- **SEREVICIUS et al.** *Physical Chemistry Chemical Physics,* 2013, vol. 15 (38), 15850
- **LI et al.** *Advanced Materials,* 2013, vol. 25 (24), 3319
- **YOUN LEE et al.** *Applied Physics Letters,* 2012, vol. 101 (9), 093306
- **NISHIMOTO et al.** *Materials Horizons,* 2014, vol. 1, 264
- **VALCHANOV et al.** *Organic Electronics,* 2013, vol. 14 (11), 2727
- **NASU et al.** *ChemComm,* 2013, vol. 49, 10385
- *CHEMICAL ABSTRACTS,* 217-59-4
- *Chem. Rev.,* 2007, vol. 107, 1233
- **M. S. ARNOLD et al.** *Appl. Phys. Lett.,* 2008, vol. 92, 053301
- **H. UOYAMA et al.** *Nature,* 2012, vol. 492 (7428), 234-238
- **K. MASUI et al.** *Organic Electronics,* 2013, vol. 14 (11), 2721-2726
- **UOYAMA, K. GOUSHI ; K. SHIZU ; H. NOMURA ; C. ADACHI.** Highly efficient organic light-emitting diodes from delayed fluorescence. *Nature,* Dezember 2012, vol. 492 (7428), 234-238